Europäisches Patentamt

(19) European Patent Office

Office européen des brevets

(11) EP 0 874 283 B1

(12) EUROPEAN PATENT SPECIFICATION

(45) Date of publication and mention
of the grant of the patent:
**03.09.2003   Bulletin 2003/36**

(51) Int Cl.⁷: **G03F 7/20**

(21) Application number: **98107355.4**

(22) Date of filing: **22.04.1998**

(54) **Optical exposure apparatus and photo-cleaning method**

Optischer Belichtungsapparat und optisches Reinigungsverfahren

Appareil d'exposition optique et méthode de nettoyage optique

(84) Designated Contracting States:
**DE FR GB IT NL**

(30) Priority: **23.04.1997   JP 10648797**
**28.05.1997   JP 15585597**
**28.05.1997   JP 15585697**

(43) Date of publication of application:
**28.10.1998   Bulletin 1998/44**

(73) Proprietor: **NIKON CORPORATION**
**Tokyo (JP)**

(72) Inventors:
• **Mori, Takashi, c/o Nikon Corporation**
  **2-3 Marunouchi 3-chome Chiyoda-ku, Tokyo (JP)**
• **Takahashi, Tetsuo, c/o Nikon Corporation**
  **2-3 Marunouchi 3-chome Chiyoda-ku, Tokyo (JP)**
• **Nakamura, Hiroshi, c/o Nikon Corporation**
  **2-3 Marunouchi 3-chome Chiyoda-ku, Tokyo (JP)**

• **Kudo, Yuji, c/o Nikon Corporation**
  **2-3 Marunouchi 3-chome Chiyoda-ku, Tokyo (JP)**

(74) Representative: **Viering, Jentschura & Partner**
**Postfach 22 14 43**
**80504 München (DE)**

(56) References cited:
**EP-A- 0 564 264          EP-A- 0 766 144**
**US-A- 4 023 126          US-A- 4 688 932**
**US-A- 4 961 001          US-A- 5 153 773**
**US-A- 5 159 483          US-A- 5 383 000**

• **PATENT ABSTRACTS OF JAPAN vol. 014, no. 028 (E-875), 19 January 1990 (1990-01-19) -& JP 01 265513 A (NEC CORP), 23 October 1989 (1989-10-23)**
• **PATENT ABSTRACTS OF JAPAN vol. 018, no. 324 (E-1564), 20 June 1994 (1994-06-20) -& JP 06 077107 A (NEC YAMAGATA LTD), 18 March 1994 (1994-03-18)**

EP 0 874 283 B1

## Description

### Field of the Invention

The present invention pertains to optical exposure apparatus and methods of using same, and in particular to such apparatus and methods wherein the optical materials comprising the apparatus are susceptible to changes in their optical properties due to the presence of matter, such as moisture and organic compounds, in the atmosphere surrounding the apparatus.

### Background of the Invention

Present-day manufacturing of semiconductor devices, which includes integrated circuits, liquid crystal displays, thin film magnetic heads, and the like, employs optical exposure apparatus and methods. The increasing degree of integration of such semiconductor devices has placed increasing demands on the optical exposure apparatus to achieve higher levels of resolution. The resolution of an optical exposure apparatus can be approximated by the relation

$$R = k \times \lambda/NA_p$$

wherein, R is the "resolution" or resolving power of the optical exposure apparatus (i.e., the size of the smallest feature that can be printed), $\lambda$ is the wavelength of the exposure light, $NA_p$ is the numerical aperture of the projection lens included therein, and k is a constant which depends upon on the type of recording medium used and the process for developing the images formed therein.

To keep up with the increasing degree of integration of semiconductor devices, continuing efforts are being made, as can be understood from the above formula, to increase the resolution of the optical exposure apparatus by shortening the wavelength of the exposure light and/or increasing $NA_p$. In recent years, KrF (krypton fluoride) excimer lasers having an output wavelength of 248 nm have been used for the exposure light source. Moreover, projection lenses $NA_p$ of 0.6 or greater have been commercialized, and features as small as 0.25 microns have been realized.

More recently, in an effort to increase resolution ArF (argon fluoride) excimer lasers having an output wavelength of 193 nm have been gaining attention as a successor light source to KrF excimer lasers. This reduction in wavelength could, in principle, allow the printing of features 0.18 microns or less. However, optical exposure apparatus operable at deep ultra-violet ("DUV", i.e., less than 200 nm) wavelengths are difficult to realize. One reason for this is that in this wavelength region, the materials available for the necessary optical components are currently limited to quartz and calcium fluoride (fluorite). For these materials to be suitable for use in DUV optical exposure apparatuses, they must have sufficient transmittance and internal uniformity (an internal transmittance of 0.995/cm or greater has been achieved with fused quartz, and negligible levels of absorption have been achieved with calcium fluorite). Also, optical components made from these materials require an anti-reflection coating on their surfaces when used at DUV wavelengths, to increase light transmission.

However, even with anti-reflection coatings and minimum levels of absorption, the optical characteristics of fused quartz and calcium fluorite can change due to the heat generated by surface contaminants which absorb DUV light. For instance, it has been discovered that the transmittance of optical components made from fused quartz and calcium fluoride drops rapidly when exposed to moisture or organic compounds. The amount of this absorption, which can reach up to 0.01 per lens surface, is large compared to the absorption due to the material itself or the surface anti-reflection coatings. Therefore, it is necessary to keep the surfaces of fused quartz or calcium fluorite optical components free of such contaminants.

Japanese patent application Kokai No. Hei 7-294705 discloses a technique relating to a method for photo-cleaning individual optical components with light (hereinafter, "photo-cleaning"). However, this technique does not disclose a method for photo-cleaning all, or the essential optical parts of, the optical components of an optical exposure apparatus after the apparatus has been assembled. It has been discovered by the present inventors that the temporary photo-cleaning of individual optical components by exposing them to DUV light actually facilitates the later absorption of ambient moisture and organic compounds onto the surfaces of the optical components. Consequently, even if individual optical components are photo-cleaned using DUV light, it is extremely difficult to assemble the optical components to form a projection exposure system, and then isolate those components completely from moisture, organic compounds, and other contaminants. This has been a major impediment in realizing a robust DUV projection exposure system.

JP-A-01 265 513 discloses an exposure device which use a first optical system to guide ultraviolet rays from a light source through a reticle onto a wafer during an exposure process, and which uses a separate, second optical system to project the ultra violet rays on the reticle for washing away organic dust adhered to the reticle by conducting a dry cleaning.

### Summary of the Invention

The present invention pertains to an optical exposure apparatus as claimed in claim 1 and a method of using same as claimed in claim 9.

An optical exposure apparatus for forming an image on a photosensitive substrate is described. The apparatus comprises an illumination optical system having a light source and a light beam. Next to the illumination optical system is a reticle having a pattern. Next to the reticle on the opposite side of the illumination optical system is a projection lens. The projection lens and the illumination optical system have a predetermined space therein. An exposure optical path (i.e., the light path associated with performing an exposure) passes through this predetermined space. An optical path deflection member is removably arranged in the predetermined space so as to cause a deflection in the exposure optical path to form a second optical path. The second optical path differs from the exposure optical path. The second optical path is the light path associated with performing photo-cleaning. The optical path deflection member can be, for example, a rotating prism or one or more moving optical components (including lenses-and mirrors).

Particularly, instead of an optical path deflection member, a light diffusing member is placed in the light beam associated with performing an exposure (i.e., the exposure light beam) so as to create a second light beam that is larger than the exposure light beam. This second light beam is the light beam associated with performing photo-cleaning.

Particularly, the optical path deflection member or light diffusing member is removably disposed within the predetermined space so that photo-cleaning can be performed between exposures.

Furthermore a method of photo-cleaning an optical exposure apparatus for forming an image on a photosensitive substrate is described. The method comprises the steps of first, forming an exposure optical path in a predetermined space within an illumination optical system and a projection lens. The second step is preventing the photosensitive substrate from being in said exposure optical path. The third step is changing the exposure optical path to an optical path that differs from said exposure optical path.

**Brief Description of the Drawings**

FIG. 1 is a schematic diagram of an embodiment of the optical exposure apparatus of the present invention, which includes a deflection prism and a single light detector located on the workpiece stage;

FIG. is a schematic diagram of an embodiment of the optical exposure apparatus of the present invention, which includes a deflection prism, a beam splitter for creating a second optical path, and single light detector located therein;

FIG. 3 is a schematic diagram of an embodiment of the optical exposure apparatus of the present invention, which includes a deflection prism, a light detector located on the workpiece stage, a beam splitter for creating a second optical path, and a light detector located therein;

FIG. 4 is a schematic diagram of an embodiment of the optical exposure apparatus of the present invention, which includes a deflection prism, a beam splitter for creating a second and third optical paths, and a light detector located in each of the second and third optical paths;

FIG. 5 is a schematic diagram of an embodiment of the optical exposure apparatus of the present invention, which includes a rotating mirror;

FIG. 6 is a schematic diagram of an embodiment of the optical exposure apparatus of the present invention, which includes a movable lens component;

FIG. 7 is a schematic diagram of an embodiment of the optical exposure apparatus of the present invention, which includes a diffusion plate, and a single light detector located on the workpiece stage;

FIG. 8 is a schematic diagram of an embodiment of the optical exposure apparatus of the present invention, which includes a diffusion plate, a beam splitter for creating a second optical path, and a single light detector located therein;

FIG. 9 is a schematic diagram of an embodiment of the optical exposure apparatus of the present invention, which includes a diffusion plate, a light detector located on the workpiece stage, a beam splitter for creating a second optical path, and a light detector located therein;

FIG. 10 is a schematic diagram of an embodiment of the optical exposure apparatus of the present invention, which includes a diffusion plate, a beam splitter for creating a second and third optical paths, and a light detector located in each of the second and third optical paths;

FIG. 11 is a schematic diagram of an embodiment of the optical exposure apparatus of the present invention, which includes a housing, a variable aperture stop, and gas supply and gas discharge systems connected to the housing and the projection lens;

FIG. 12 is a front view of the variable aperture stop utilized in the optical exposure apparatus of FIG. 11, wherein the aperture stop has eight different apertures;

FIG. 13 shows the superposition of several of the apertures of the aperture stop of FIG. 12;

FIG. 14 is a schematic diagram of a preferred embodiment of a projection lens of the present invention which has several lens chambers and supply and discharge conduits for permitting gas flow through the chambers; and

FIG. 15 is a schematic diagram of a preferred embodiment of a photo-cleaning apparatus of the present invention.

## Detailed Description of the Invention

The present invention pertains to optical exposure apparatuses and methods, and in particular to such apparatuses and methods wherein the optical materials comprising the apparatus are susceptible to changes in their optical properties due to the presence of matter, such as moisture and organic compounds, in the atmosphere surrounding the apparatus. Such apparatuses include, for example, DUV-wavelength optical exposure or projection exposure apparatuses for semiconductor manufacturing, which utilize optical components made from synthetic quartz and/or calcium fluoride.

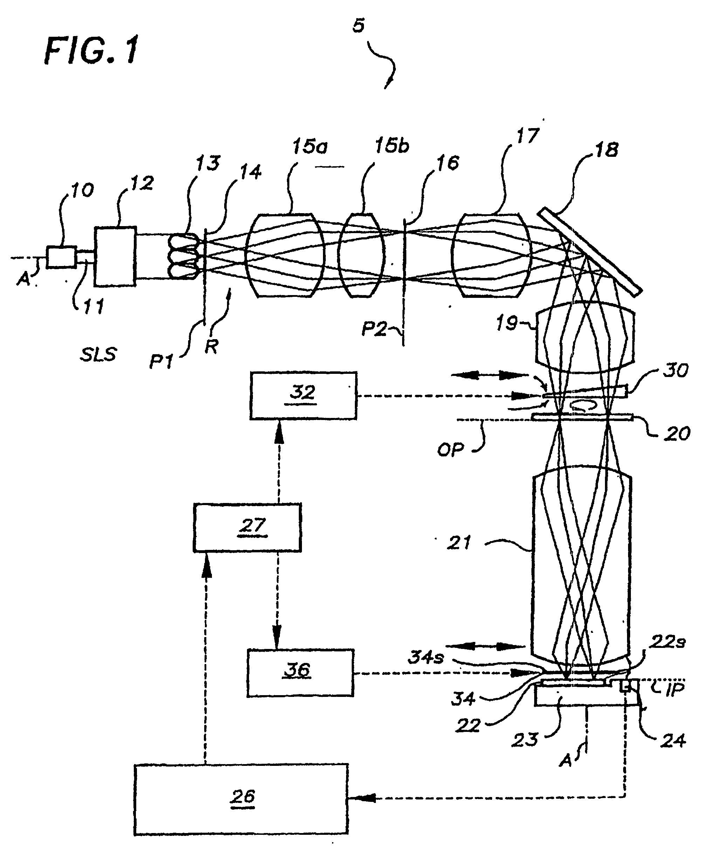

Referring to FIG. 1, optical exposure apparatus 5 includes, along an optical axis A, a light source 10 which emits a light beam 11. Light source 10 may be, for example, an ArF excimer laser emitting light at 193 nm. Adjacent light source 10 is a beam-shaping optical system 12, which adjusts the shape of light beam 11. An optical integrator 13 is located immediately adjacent optical system 12. Optical integrator 13 has a plurality of lens segments (three are shown) and can be, for example, a fly's-eye lens (i.e., a bundle of elongated optical elements, similar to that shown in FIG. 1), or an internal-reflection light pipe. Further, optical integrator 13 is not limited to being a single optical component, but may be a plurality of optical integrators arranged in series to achieve greater light beam uniformity.

Further included in optical exposure apparatus 5 adjacent optical integrator 13 is a first image plane P1 at which an aperture stop 14 is located. Adjacent aperture stop 14 is a front condensing lens 15a and a rear condensing lens 15b. Adjacent rear condensing lens 15b is a second image plane P2 at which an adjustable field stop 16 is located. Adjacent field stop 16 and second image plane P2 is a first objective lens 17, a fold mirror 18 and a second objective lens 19. The above-described optical components from front condensing lens 15a through second objective lens 19 constitute a condenser optical system. The above-described optical components from light source 10 to second objective lens 19 constitute an illumination optical system.

With continuing reference to FIG. 1, a reticle 20 is located optically conjugate to field stop 16, at the illumination optical system image plane (not shown) as defined by objective lenses 17 and 19. Reticle 20 contains small patterns (not shown) to be imaged. Adjacent reticle 20 is a projection lens 21 having an object plane OP and an image plane IP. Object plane OP of projection lens 21 is located optically conjugate to field stop 16, as defined by objective lens 17 and 19 (thus, reticle 20 is located at object plane OP). Projection lens 21 may be, for example, a dioptric or catadioptric high-performance DUV photolithographic lens comprising fused quartz and/or calcium fluoride optical components. Disposed at or near image plane IP of projection lens 21 is a workpiece 22 having a surface 22s. Workpiece 22 may be, for example, a wafer coated with a light-sensitive recording medium, such as photoresist. Workpiece 22 is positioned and held in place by a movable workpiece stage 23. A light detector 24 is located on workpiece stage 23, and can be moved into the optical path underneath projection lens 21 to measure the intensity of the light passing therethrough. Light detector 24 is connected to a light detection system 26, which is connected to a control system 27. Here, light detection system 26 has the function for detecting light transmittance. Light detector 24 may be, for example, a photoelectric sensor, which converts light energy into an electrical signal.

With continuing reference to FIG. 1, optical exposure apparatus 5 further includes a rotatable deflection prism 30. Deflection prism 30 is inserted and removed from a predetermined space within optical exposure apparatus 5, which contains an optical path (i.e., light rays R) between second objective lens 19 and reticle 20, by a drive system 32 which is connected to control system 27. Also included in optical exposure apparatus 5 is a shutter 34. Shutter 34 is inserted and removed from the optical path (i.e., light rays R) between projection lens 21 and workpiece 22 by a drive system 36, which is also connected to control unit 27. When shutter 34 is inserted in the optical, the shutter is "closed," and when the shutter is removed from the optical, it is "open."

With continuing reference to FIG. 1, the operation of optical exposure apparatus 5 in exposing workpiece 22, in the absence of deflection prism 30 and shutter 34, is now described. First, light source 10, when activated, emanates light beam 11, which passes through beam-shaping optical system 12. Beam-shaping optical system 12 adjusts the shape (e.g., collimates and spatially filters) light beam 11 so that it has the appropriate dimensions prior to the light beam entering optical integrator 13. Optical integrator 13 then forms a plurality of images or secondary light sources SLS at image plane P1. Aperture stop 14, located at image plane P1, serves to limit the extent of light rays R emanating from secondary light sources SLS. Front and rear condensing lenses 15a and 15b then superimpose each light source of secondary light sources SLS to form a single, overlapping image (not shown) at image plane P2, as indicated by the path of light rays R. The image formed at image plane P2 has an intensity distribution that is highly uniform due to the superposition of the light sources of secondary light sources SLS.

Field stop 16, located at second image plane P2, serves to define the shape of the image formed at image plane P2. Light from the image formed at image plane P2 is relayed by first objective lens 17, fold mirror 18 and second objective lens 19 to object plane OP of projection lens 21 (coincident with the illumination optical system image plane, not shown), at or near which reticle 20 resides. Reticle 20 is thus uniformly illuminated, and an image of the pattern located thereon is projected onto surface 22a of workpiece 22 by projection lens 21. The optical path defined by light rays R (with or without reticle 20 present) is referred to herein as the exposure optical path. This is the optical path light from light source 10 follows through the predetermined space within the optical exposure apparatus when the optical exposure apparatus is arranged to perform an exposure to pattern the workpiece.

As mentioned above, for DUV optical exposure apparatus using fused quartz and/or calcium fluoride optical components, moisture and organic matter in the atmosphere surrounding the optical exposure apparatus tends to adhere to and contaminate the surfaces of the optical components. This changes the optical properties of the components, in particular reducing the transmittance of the refractive optical components and the reflectance of reflecting optical components. When light source 10 is a DUV light source and is activated (or alternatively, when aperture stop 14 or field stop 16 is opened) to perform an exposure of workpiece 22, the contaminated optical components are, to a certain extent, photo-cleaned by the DUV light passing therethrough. However, the present inventors have found that recontamination can quickly occur between exposures. Also, the photo-cleaning does occur during exposure of the workpiece reduces the intensity of the exposure beam.

Accordingly, in the present invention, optical exposure apparatus 5 is configured so that, prior to exposing workpiece 22, a photo-cleaning process can be performed whereby light from light source 10 passes through each optical component in a manner that eliminates contamination from their respective surfaces. In this regard, the role of deflection prism 30 and shutter 34 is to provide light of sufficient intensity for photo-cleaning over the entire area desired for one or more optical components in optical exposure apparatus 5. Deflection prism 30 deflects light in the exposure optical (i.e., light rays R) entering projection lens 21, by a deflection angle $\Delta$ (not shown), which is a function of the prism wedge-angle a (not shown). Deflection prism 30 is rotatable by drive system 32 such that light rays R can be deflected to pass through portions, including the peripheral portions, of the optical components in projection lens 21 (i.e., the portions of the optical components other than those traversed by the exposure optical path).

To appreciate the importance of deflection prism 30 in performing photo-cleaning, it is useful to consider the photo-cleaning options available in optical exposure apparatus 5 of FIG. 1 without it. The first option is to perform photo-cleaning with reticle 20 removed.

This would be preferred because the patterns on the reticle absorb light, reducing the intensity of the light passing through projection lens 21 resulting in less efficient photo-cleaning. However, the numerical aperture $NA_p$ of projection lens 21 is generally greater than numerical aperture $NA_i$ of the illumination optical system so that the projection lens can collect light diffracted from the pattern on reticle 20. This diffracted light is part of the exposure optical path and traverses certain peripheral portions of the optical components of projection lens 21. Accordingly, with reticle 20 removed, there is more light available for photo-cleaning, but the light will only traverse the optical components of projection lens 21 out to a radial distance defined by $NA_i$. The other option is to keep reticle 20 in place during photo-cleaning, so that certain peripheral portions of the optical components receive diffracted light. However, the diffracted light from typical reticle patterns does not have the necessary intensity for effective photo-cleaning.

In performing photo-cleaning using deflection prism 30, it is desirable to arrange deflection prism 30 such that deflection angle $\Delta$ satisfies the relationship $\Delta \geq NA_p - NA_i$. This ensures that the peripheral portions of the optical components (including those portions traversed and not traversed by the exposure optical path) will be photo-cleaned. Note that there is no need to reduce $NA_i$ during photo-cleaning, and it is generally preferable to set $NA_i$ at its maximum value.

With continuing reference to FIG. 1, insertion of shutter 34 into the optical path between projection lens 21 and workpiece 22 prevents exposure of workpiece 22 during photo-cleaning. Thus, replacement and/or aligning of the workpiece can be performed simultaneous with photo-cleaning. In a preferred embodiment, shutter 34 has a surface 34s facing projection lens 21 that is reflective. Thus, light rays R incident on shutter surface 34s are reflected back through projection lens 21 and through the rest of optical exposure apparatus 5, thereby enhancing the photo-cleaning effect. Shutter 34 can also be tilted with respect to optical axis A passing therethrough, by means of drive system 36, thereby allowing for greater deflection of the light in the optical path, which increases the effectiveness of photo-cleaning.

The photo-cleaning process, as described above, can be performed with or without reticle 20 being present. However, when reticle 20 is present the time required for photo-cleaning increases due to light being absorbed by the reticle pattern. On the other hand, if reticle 20 is removed, the time required for photo-cleaning is shorter, but there is the added time is required for removing and inserting reticle 20. Accordingly, if the time needed for removing and inserting reticle 20 makes the overall photo-cleaning process longer, then it may be preferable to perform photo-cleaning with reticle 20 present.

Also, though deflection prism 30 is shown in FIG. 1 disposed between objective lens 19 and reticle 20, deflection prism 30 can be disposed anywhere in optical projection exposure system 5. For example, it may be disposed between reticle 20 and projection lens 21, between aperture stop 14 and front condenser lens 15a, between field stop 16 and reticle 20, or within projection lens 21 itself. Generally speaking, deflection prism 30 should be disposed "upstream" (i.e., on the light-source 10 side) the optical component or components that require photo-cleaning.

With continuing reference to FIG. 1, light detector 24 located on workpiece stage 23, is used to measure the intensity of light passing through projection lens 21. This is accomplished by moving workpiece stage 23 in a direction parallel to image plane IP such that light detector 24 is inserted into the optical exposure path. When shutter 34 is opened, light is incident on light detector 24, and the output (e.g., an electrical signal) therefrom is inputted and stored in light detection system 26. By comparing such light intensity measurements made at various points in time and stored in light detection system 26, the combined transmittance of the optical components in optical exposure apparatus 5 can be immediately determined and compared to an "optimum" transmittance corresponding to the "cleanest" state of optical exposure apparatus 5. Accordingly, a decision for whether or not to start the photo-cleaning process and whether or not to end the photo-cleaning process can be easily made. Alternatively, light detection system 26 can include an arbitrary threshold illumination intensity value, for deciding when photo-cleaning should commence.

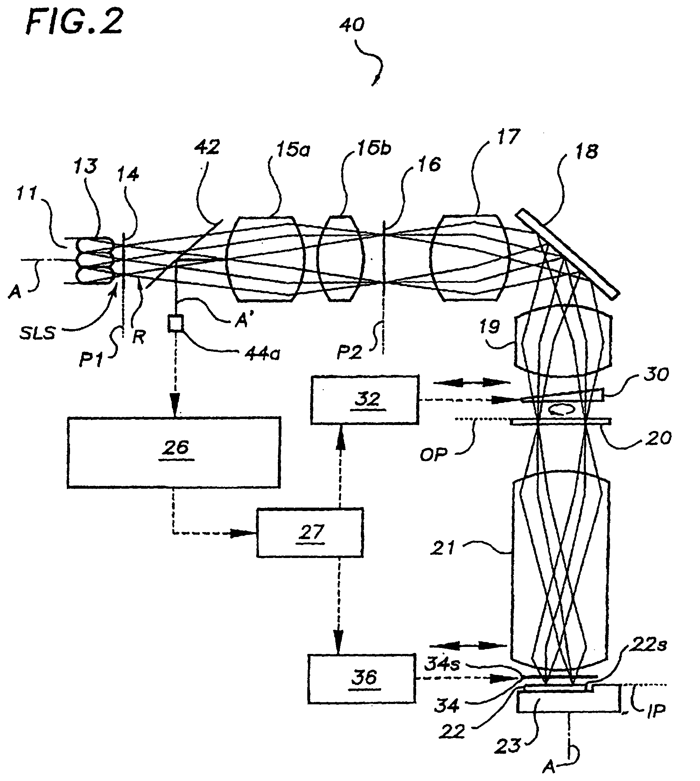

It may be desirable to measure the light intensity of optical exposure apparatus 5 of FIG. 1 at workpiece surface 22s when shutter 34 is closed. Thus, with reference now to FIG. 2, optical exposure apparatus 40 represents another preferred embodiment of the present invention which allows for this measurement. Optical exposure apparatus 40 includes the same elements as optical exposure apparatus of FIG. 1, except that light detector 24 is removed. Optical exposure apparatus 40 further includes a beam splitter 42 disposed between aperture stop 14 and front condensing lens 15a, and a light detector 44a. Beam splitter 42 is disposed such that it creates an optical axis A' at right angles to optical axis A passing therethrough. Light detector 44a is disposed along optical axis A'.

In optical exposure apparatus 40, light reflected from reflective surface 34s of shutter 34 when shutter 34 is closed, and travels back up through the optical exposure apparatus and backwards through condensing lens 15a. A portion of this light is then reflected by beam splitter 42 along optical axis A' to light detector 44a. In this way, the light transmittance of optical exposure apparatus 40 during the photo-cleaning process can be measured in real-time, which is useful in deciding when the photo-cleaning process should terminate. Note that though beam splitter 42 is disposed between aperture stop 14 and front condensing lens 15a, it can be disposed anywhere in optical exposure apparatus 40, including anywhere in the illumination optical system or projection lens 21.

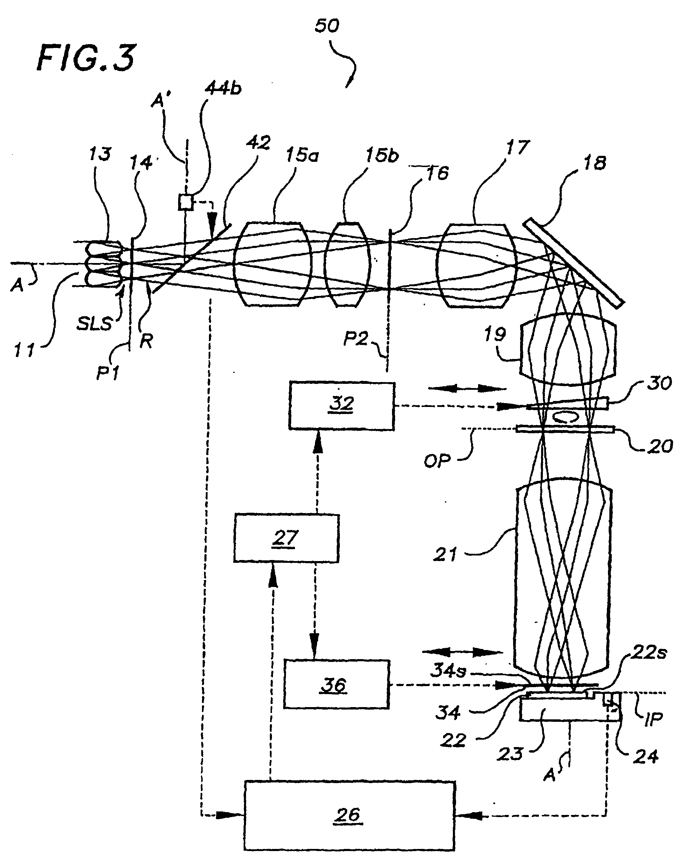

Certain optical exposure apparatuses include light sources whose light beam fluctuates in intensity. In such apparatuses, it is desirable to be able to distinguish between light beam intensity fluctuations due to the light source and fluctuations in the transmittance of the optical exposure apparatus due to contaminated optical components. Thus, with reference to FIG. 3, an optical exposure apparatus 50 represents a preferred embodiment of the present invention which can make such a distinction. Optical exposure apparatus 50 includes the same elements as optical exposure apparatus 5 of FIG. 1, except that a beam splitter 42 is added (as shown in optical exposure apparatus 40 of FIG. 2 and described above), and light detector 44b is disposed along axis A' such that it receives light reflected by beam splitter 42 prior to the light entering front condensing lens 15a. The outputs of light detectors 24 and 44b are inputted into light detection system 26, where the transmittance of optical exposure apparatus 50 is derived based on the difference in the light detector outputs. In this configuration, fluctuations in the intensity of light emitted by light source 10 are detected by both light detectors 24 and 44b and can thus be subtracted from the transmittance calculation. Note again that beam splitter 42 may be placed anywhere in optical exposure system 50. For example, if the transmittance of projection lens 21 is to be determined, beam splitter 42 can be disposed between reticle 20 and projection lens 21, with detector 44b disposed along optical axis A' formed by beam splitter 42.

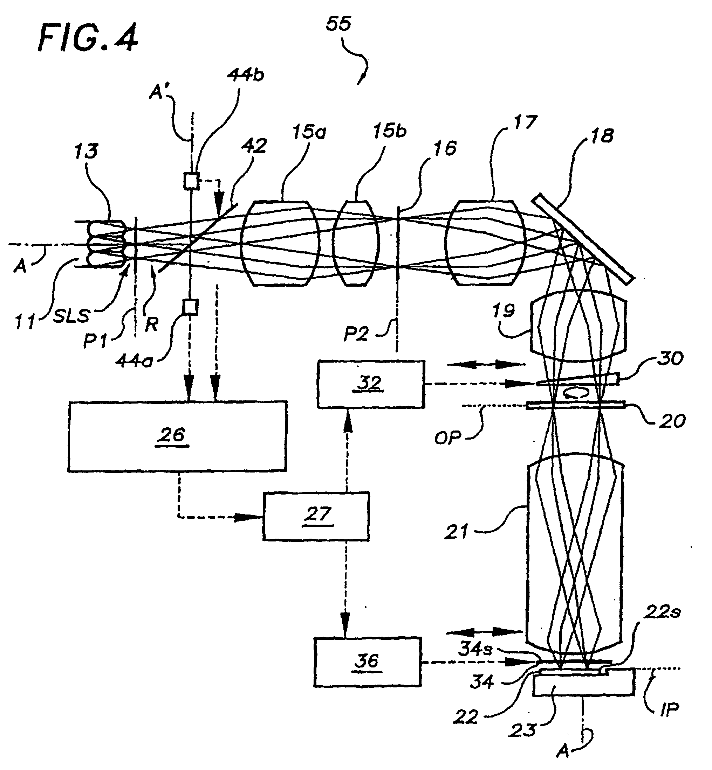

In optical exposure apparatus 50 of FIG. 3, the light intensity at workpiece surface 22s cannot be measured when shutter 34 is closed. Thus, with reference to FIG. 4, an optical exposure apparatus 55 represents a preferred embodiment of the present invention, which is a modification of optical exposure apparatus 50 to allow for this measurement. Optical exposure apparatus 55 includes the same elements as optical exposure apparatus of FIG. 2, and it further includes light detector 44b, as shown in FIG. 3. In this configuration, light detector 44b detects light reflected by beam splitter 42 prior to the light entering front condensing lens 15a. Light detector 44a detects light reflected by reflective surface 34s of shutter 34 which passes back through optical projection system 5 and backwards through front condenser lens 15a. The outputs of light detectors 44a and 44b are inputted into light detection system 26. Comparison of the outputs from light detectors 44a and 44b allows for the transmittance of optical exposure apparatuses between front condensing lens 15a and shutter 34 to be continuously monitored, regardless of the fluctuation in light intensity emitted by light source 10, when shutter 34 is closed.

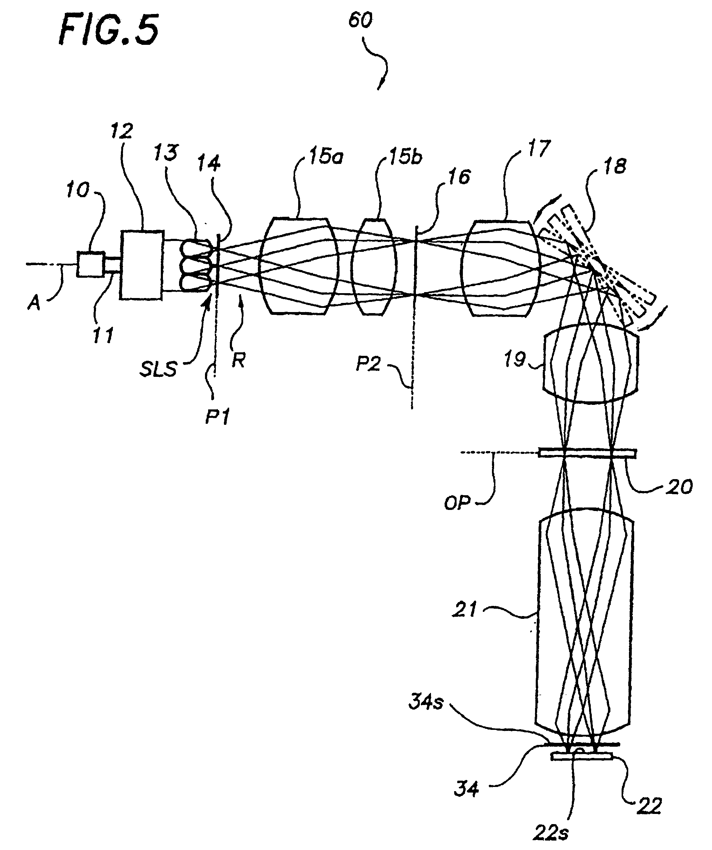

Optical exposure apparatuses 5, 40, 50, and 55, discussed above, all employ deflection prism 30 to deflect the optical path during photo-cleaning. With reference now to FIG. 5, optical exposure apparatus 60 represents a preferred embodiment of the present invention which employs a different means for deflecting the light path to perform photo-cleaning. Optical projection exposure apparatus 60 includes the same elements as optical exposure apparatus of FIG. 1, except that deflection prism 30 is no longer present. Instead, fold-mirror 18 is made movable in two-dimensions (FIG. 5 illustrates the movement in one-dimension). For example, fold-mirror 18 may be rapidly oscillated in two dimension about its center or some other position. Moreover, the movement of fold-mirror 18 may be combined with a lateral shift. The movement of fold-mirror 18, as described above, serves to deflect the optical path to peripheral portions of the optical components in optical apparatus 60 during photo-cleaning. Note that fold-mirror 18, like deflection prism 30, can be located in at any other convenient location in the illumination optical system.

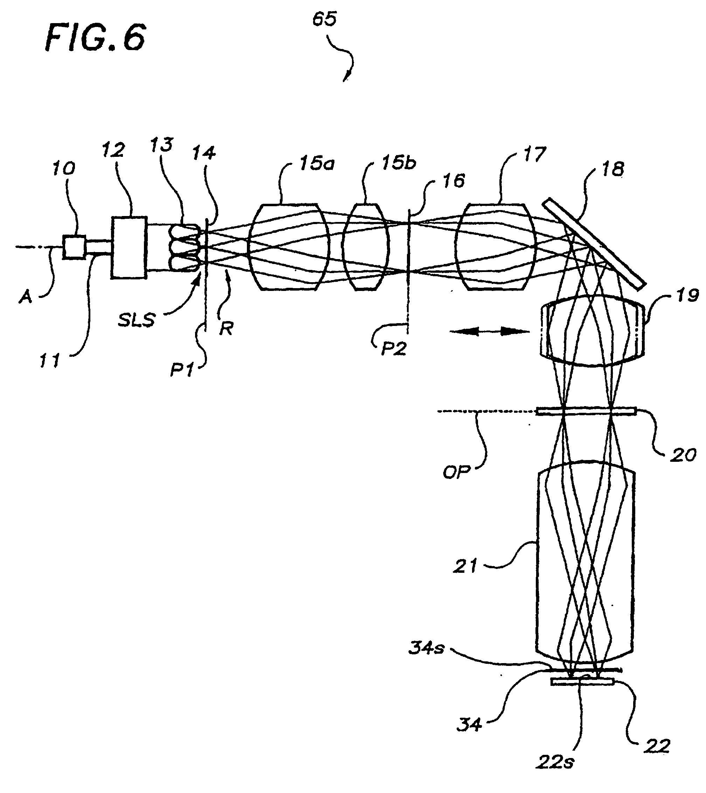

With reference now to FIG. 6, optical exposure apparatus 65 represents another preferred embodiment of the present invention which employs a different means for deflecting the light path to perform photocleaning. Optical exposure apparatus 65 includes the same elements as optical exposure apparatus of FIG. 1, except that deflection prism 30 is no longer present. Instead, objective lens 19 may be moved rapidly back and forth (i.e., oscillated) in a direction perpendicular to optical axis A passing therethrough. Objective lens 19 may also simultaneously be moved along optical axis A passing therethrough. The movement of objective lens 19, as described above, serves to deflect light in the optical path during photo-cleaning. Note that other optical components in optical exposure apparatus 65, such as condenser lenses 15a and/or 15b can be can be made movable in instead of, or in addition to, objective lens 19.

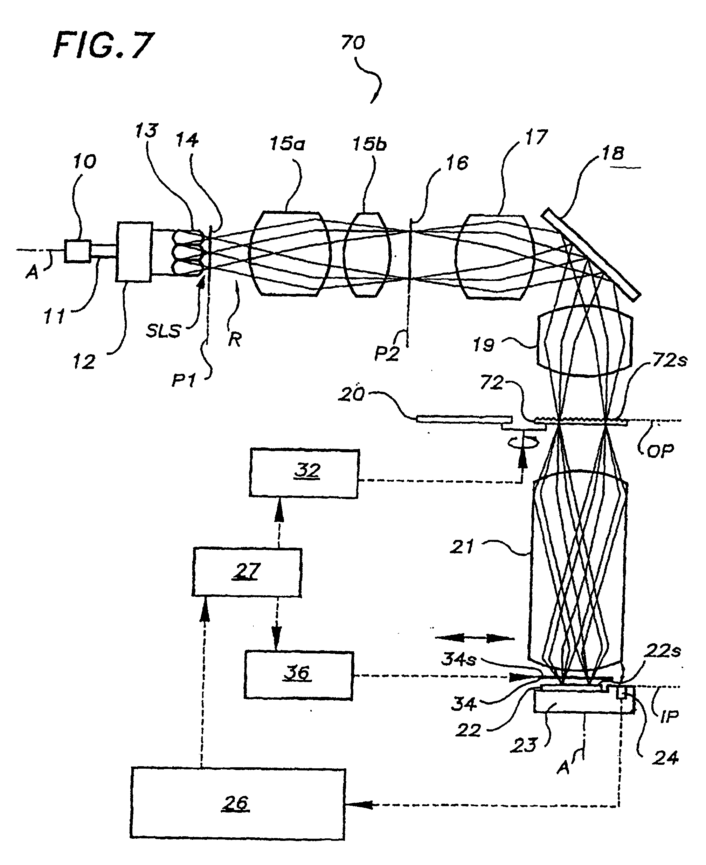

With reference now to FIG. 7, optical exposure system 70 is another preferred embodiment of the present invention which employs yet another means for deflecting light in the optical path to perform photocleaning. Optical exposure system 70 includes the same elements as FIG. 1, except that deflection prism 30 is absent. Instead, a light diffusing member, such as a diffusion plate 72 is inserted at or near object plane OP of projection lens 21. Diffusion plate 72 is connected to drive system 32, which removes reticle 20 and inserts diffusion plate 72 in its place for photo-cleaning. Drive system 32 also removes diffusion plate 72 and inserts reticle 20 in its place for exposure. Diffusion plate 72 may be, for example, a fused quartz or calcium fluoride plate having a pattern etched in on one of its surfaces, such as surface 72s. The pattern on surface 72s may be periodic, such a diffraction grating, to diffract light incident thereon, or may be random to scatter light incident thereon. The degree to which diffusion plate 72 diffuses light can be characterized by a diffusion angle $\Delta'$, similar to the deflection angle of the deflection prism, discussed above. If the diffusion angle $\Delta'$ is too large due to the pattern on surface 72s being too rough, it can be controlled by processing the surface with chemicals such as hydrofluoric acid (hydrogen fluoride). In addition, if diffusion plate 72 includes a diffraction grating, the diffusion angle $\Delta'$ can be controlled by adjusting the grating spacing.

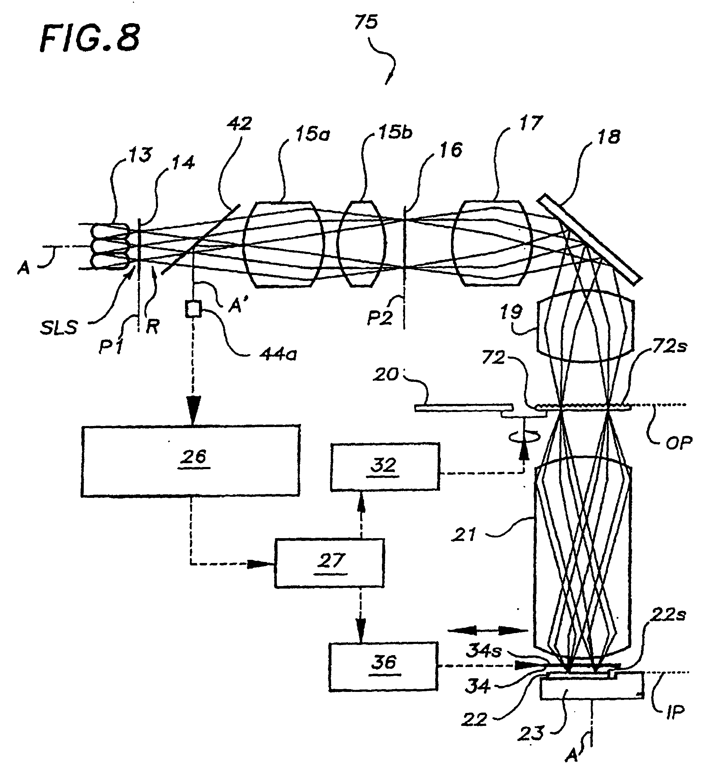

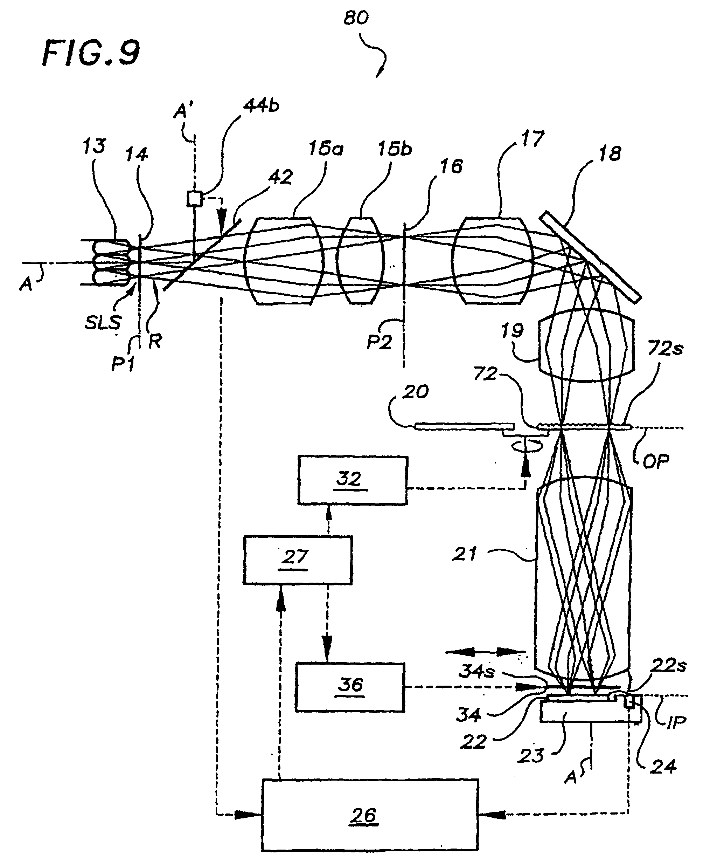

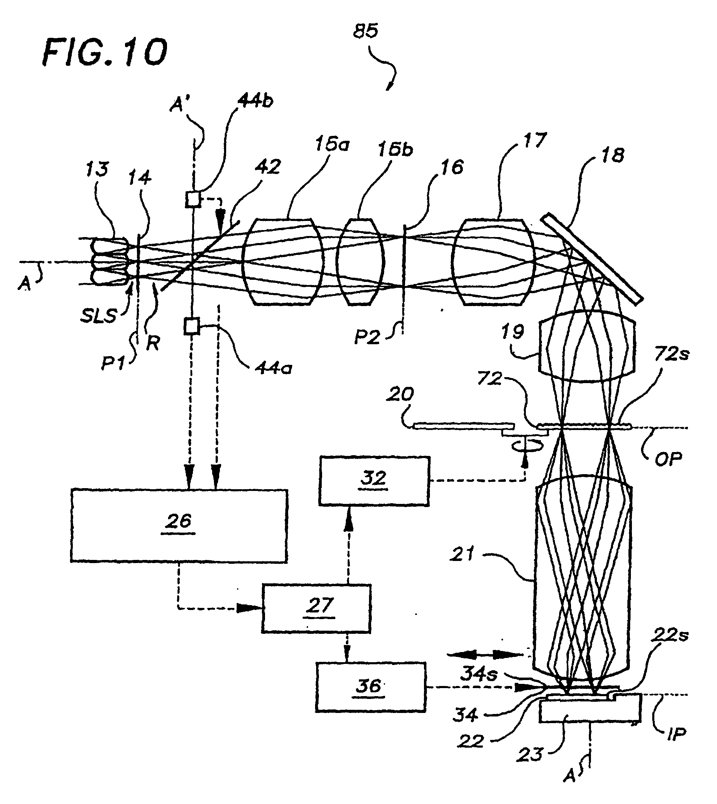

As discussed above in connection with deflection prism 30 (see FIGS. 1-4), it is generally preferred to set the diffusion angle $\Delta'$ such that $\Delta' = NA_p - NA_i$ to ensure the periphery of the optical components receive light during photo-cleaning. Also, diffusion plate 72 can be used in analogous fashion to deflection prism 30 as it is used in optical exposure apparatuses 5, 40, 50 and 55 shown in FIGS. 1-4. FIGS. 7-10 show optical exposure apparatuses 70, 75, 80 and 85 which include diffusion plate 72 and which operate in the same manner as optical exposure apparatuses 5, 40, 50 and 55, respectively, which include deflection prism 30, as discussed above.

As can be appreciated from the above discussion, realizing a robust DUV optical exposure apparatus and a method of patterning a workpiece using the apparatus is extremely difficult because of the aforementioned contamination of the optical components. It is a particularly daunting problem because it is virtually impossible to reduce the humidity to zero or to eliminate the presence of organic compounds, which are ubiquitous in a semiconductor manufacturing environment. Accordingly, it is essential to have an optical exposure apparatus and method that incorporates photo-cleaning techniques which allow for a high transmittance to be maintained when performing exposures.

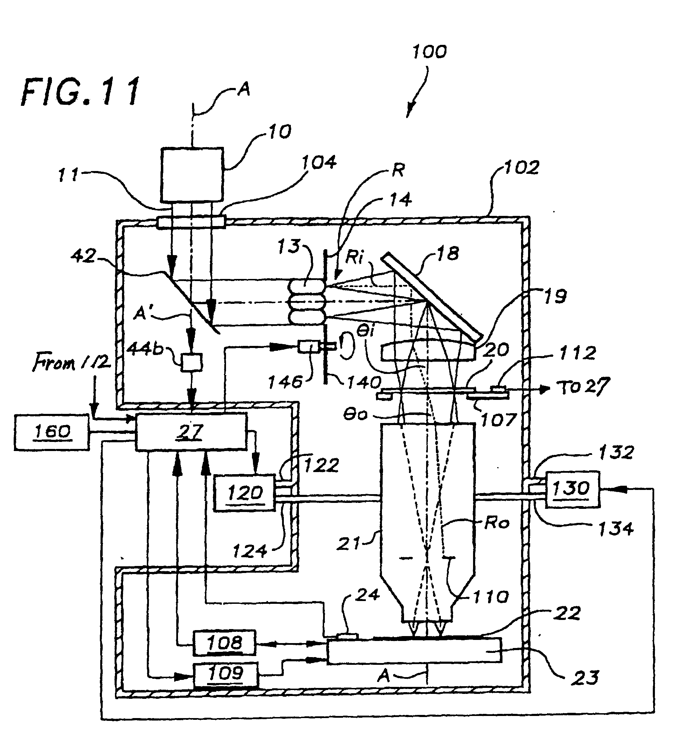

Thus, with reference now to FIG. 11, there is shown a preferred embodiment of an projection exposure apparatus 100 of the present invention for patterning a workpiece. As shown in FIG. 11, laser light is supplied as a nearly parallel light beam from light source 10, which is, for example an ArF excimer laser that oscillates pulsed light having an output wavelength of 193 nm. This laser light beam is guided to light transmitting window 104 on the side of projection exposure apparatus 100. Accordingly, projection exposure apparatus 100 is housed in a chamber 102 and filled with an inert gas like nitrogen, for example, to prevent the adherence of moisture and organic matter and the like in the atmosphere, to the optical elements and the like in chamber 104.

The laser light passing through light transmitting window 104 is reflected by reflective mirror 42, and guided to optical integrator ("fly's-eye lens") 13. Fly's-eye lens 13 is constituted by bundling numerous lens elements, and a light source image is formed on the exit surface side of these lens elements. Accordingly, at the exit surface side of fly's-eye lens 13, numerous light source images (i.e., secondary light sources, not shown) corresponding to the number of lens elements comprised thereof are formed.

Nevertheless, although one fly's-eye lens 13 is provided in the present example, a fly's-eye lens can also be provided as a second optical integrator between fly's-eye lens 13 and light source 10 or reflective mirror 42. Furthermore, an internal reflection-type rod-shaped optical member can also be used in place of fly's-eye lens 13.

In addition, as discussed later in detail, a variable aperture stop 14 (changing apparatus or changing means that can change the numerical aperture $NA_i$ of the illumination optical system) which can set a plurality of aperture stops having a predetermined shape or a predetermined size at a position wherein the numerous secondary light sources formed by the fly's-eye lens 13 are formed, is included.

The light beam from the numerous secondary light sources formed by the fly's-eye lens 13 is reflected by reflective mirror 18, and subsequently condensed by condenser optical system 19, comprising a plurality of refractive optical elements, like lenses. Consequently, the pattern, such as a circuit pattern, formed on reticle 20 is superimposingly and uniformly illuminated. Then, the image of the circuit pattern on reticle 20 is formed on workpiece 22 (e.g., a wafer coated with resist) by means of projection lens 21. Consequently, the resist coated on the wafer is exposed and the circuit pattern image is transferred onto workpiece (wafer) 22. Furthermore, projection lens 21 in the present example completely comprises optical elements like refractive lenses, and an aperture stop 110 is arranged at the position of the pupil (entrance pupil) of projection lens 21. In addition, aperture stop 110 and variable aperture stop 16 are at optically conjugate positions.

Accordingly, reticle 20 is supported by reticle stage 107 that moves two-dimensionally within the plane orthogonal to the paper surface of FIG. 11. The position information from measurement systems, like an interferometer system (not shown), that measures the position of reticle stage 107 is input to control system 27 as the controlling means. Control system 27 controls the position of reticle stage 107 via a drive system (not shown) based on this position information.

In addition, workpiece (wafer) 22 is mounted on workpiece (wafer) stage 23 that moves two-dimensionally in the plane orthogonal to the paper surface of FIG. 11. The position information from measurement system 108, like an interferometer system, that measures the position of this wafer stage 23 is input to control system 27 as the controlling means. Control system 27 controls the position of workpiece (wafer) 23 via a drive system 109 based on this position information.

In addition, in the projection exposure apparatus shown in FIG. 11, a transmittance measurement system is provided to perform measurements related to the transmittance of the illumination optical system 42 to 19 and projection lens 21. A first detector 44b related to the transmittance measurement system is arranged below reflective mirror 44b, and a second detector 24 related to the transmittance measurement system is arranged at one end of workpiece (wafer) stage 23. Furthermore, a third detector 112 related to the transmittance measurement system is arranged at one end of reticle stage 107.

First, first detector 44b provided below reflective mirror 42, (which, in this case, is partially transmitting) and detects the output of ArF excimer laser light from light source 10 by photoelectrically detecting the quantity of light, and the illumination intensity and the like of the transmitted light from one part of reflective mirror 42. Then, the output from first detector 44b is input to control system 27 as the controlling means.

In addition, by setting, via drive system 109, second detector 24, provided at one end of workpiece (wafer) stage 23, in the plane wherein the workpiece (wafer) 22 is arranged as the surface to be irradiated (or the image plane of projection lens 21), the quantity of light and illumination intensity and the like at the plane wherein wafer 22 is arranged (or the image plane of projection lens 21) are detected. Then, the output from second detector 24 is input into control system 27 as the controlling means.

Furthermore, by setting, via a drive system (not shown), third detector 112, provided at one end of reticle stage 107, in the plane wherein reticle 20 is preferably arranged, the quantity of light and illumination intensity and the like of the illumination light beam supplied to the surface of reticle 20 are measured. Then, the output from third detector 112 is input to control system 27 as the controlling means.

A divider unit and discrimination unit (not shown) are provided inside control system 27. The divider unit outputs to the discrimination unit the value of the output from second detector 24 divided by the output from first detector 44b (value corresponding to the light transmittance of reflective mirror 42, condenser optical system 19 and projection lens 21), or the value of the output from third detector 112 divided by the output from second detector 24 (value corresponding to the light transmittance of projection lens 21). Then, the discrimination unit judges whether the transmittance of the projection exposure apparatus has dropped by discriminating whether the output from the divider unit has reached a predetermined threshold value. Then, discrimination unit starts the exposure operation or continuously executes the exposure operation, or judges whether to start the photo-cleaning operation.

In addition, a gas supply apparatus 120 for supplying an inert gas like nitrogen to chamber 102 and a plurality of spaces formed between a plurality of optical components inside projection lens 21, and a gas discharge apparatus 130, for discharging the gas inside chamber 102 and the gas inside a plurality of spaces formed between a plurality of optical components inside projection lens 21, are provided outside of chamber 102. Furthermore, the inert gas is not limited to nitrogen, and gases like helium and argon can also be used.

Then gas supply apparatus 120 supplies inert gas (dried inert gas) like dried nitrogen to chamber 102 through pipe 122, and also supplies inert gas (dried inert gas) like dried nitrogen into projection lens 21 through pipe 124. In addition, gas discharge apparatus 130 discharges, through pipe 132, the gas inside chamber 102, and also discharges through pipe 134 the gas inside projection lens 21. The operation of gas supply apparatus 120 together with gas discharge apparatus 130 is controlled by control system 27.

Next, variable aperture stop 14 as the changing apparatus or changing means that changes the numerical aperture $NA_i$ of the illumination optical system in projection exposure apparatus 100 discussed above, will be explained.

The $\sigma$ value as the coherence factor (or, illumination coherence) is defined by the formula $\sigma = NA_i/NA_p$, wherein, $NA_i = \sin\theta_i$ is the numerical aperture of illumination optical system determined by ray $R_i$ parallel to optical axis A passing therethrough from the outermost circumference (outermost diameter) of variable aperture stop 14, and $NA_p = \sin\theta_o$ is the numerical aperture on the illumination optical system side of projection lens 21 determined by ray $R_o$ parallel to optical axis a passing through projection lens 21 from the outermost circumference (outermost diameter) of aperture stop 110 in projection lens 21, as shown in FIG. 11.

Furthermore, aperture stop 110 is optically conjugate to variable aperture stop 14 in the illumination optical system. Since the image of variable aperture stop 14 (image of secondary light sources) is formed at the pupil of projection lens 21, the $\sigma$ value as the coherence factor can also be defined by the following formula, wherein $D_{14}$ is the diameter of the image of variable aperture stop 14, and $D_{110}$ is the diameter of aperture stop 110 of projection lens 21:

$$\sigma = D_{14}/D_{110}.$$

Generally, projection exposure apparatus is constituted so that the $\sigma$ value of the projection exposure apparatus in the photolithography process is set to the range of 0.3 - 0.8. In the present example, variable aperture stop 14 shown in FIG. 11 is settably provided at the secondary light source position formed by fly's-eye lens 13.

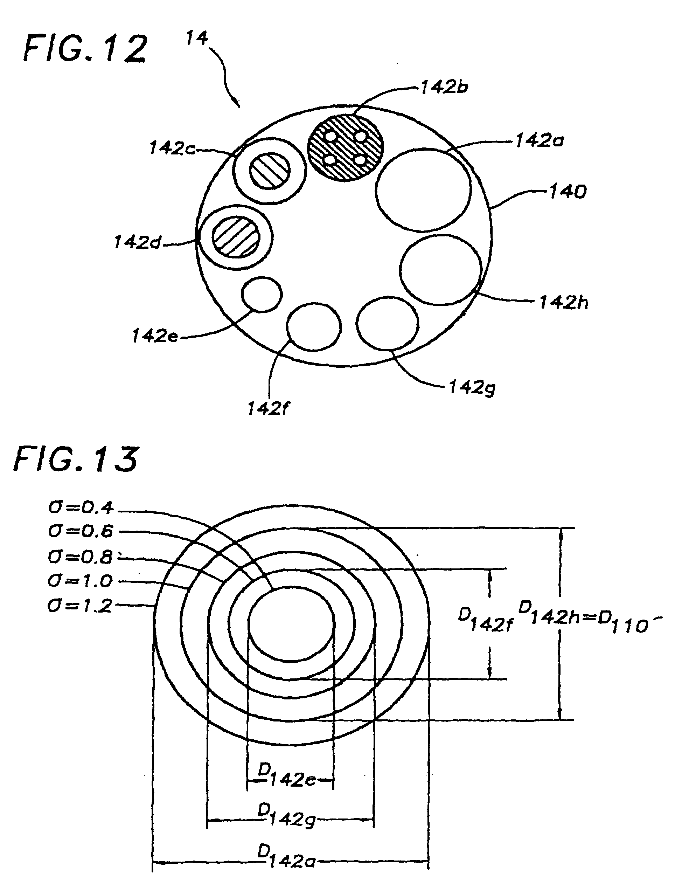

FIG. 12 shows a more concrete configuration of variable aperture stop 14 shown in FIG. 11. As shown in FIG. 12, variable aperture stop 14 has turret plate 140 having eight aperture stops 140a-140h formed on a transparent substrate, like quartz. Aperture stops 140a, 140e to 140h having five circular apertures are for the purpose of actively changing the $\sigma$ value. Among these, three aperture stops 140e, 140f, 140g are used during the actual exposure operation. The remaining two aperture stops 140a, 140h are used during the photo-cleaning operation.

Furthermore, the other three aperture stops having modified apertures are for the purpose of improving the resolving power of projection lens 21 by using them during the exposure operation. Among these, the two aperture stops 140c, 140d have annular apertures with mutually differing annular ratios. The remaining one aperture stop 140b is a stop having four off-centered apertures in order to form four off-centered secondary light sources.

Turret plate 140 having eight aperture stops 140a - 140h is rotated via drive system 146, such as a motor, shown in FIG. 11. One aperture stop among the eight aperture stops, namely an aperture stop having a desired aperture shape, is set at the secondary light source position by driving system 146, which is controlled by control system 27.

FIG. 13 shows the images of aperture stops 140a, 140e to 140h, having circular apertures of mutually differing sizes, formed on aperture stop 110 inside projection lens 21. First, if aperture stop 140e having the smallest circular aperture is set in the illumination optical path, numerical aperture $NA_i$ of the illumination optical system becomes the smallest. At this time, the image of aperture stop 140e having aperture diameter $D_{140e}$ is formed inside projection lens 110 having aperture diameter $D_{110}$ and the $\sigma$ value is set to 0.4. In other words, the relation $\sigma = D_{140e}/D_{110} = NA_i/NA_p = 0.4$ is established. Accordingly, if aperture stop 140e is set inside the illumination optical path, the pattern of reticle 20 can be transferred onto workpiece (wafer) 22 based on a value of 0.4.

In addition, if aperture stop 140f, having a circular aperture larger than aperture stop 140e, is set in the illumination optical path, then numerical aperture $NA_i$ of the illumination optical system becomes larger than when aperture stop 140e was set in the illumination optical path. At this point, the image of aperture stop 140f having aperture diameter $D_{140f}$ is formed inside projection lens 21 having aperture diameter $D_{110}$, and the $\sigma$ value is set to 0.6. In other words, the relation $\sigma = D_{140f}/D_{110} = NA_i/NA_p = 0.6$ is established. Accordingly, if aperture stop 140f is set inside the illumination optical path, the pattern of reticle 20 can be transferred onto workpiece (wafer) 22 based on a $\sigma$ value of 0.6.

In addition, if aperture stop 140g, having a circular aperture larger than aperture stop 140f, is set in the illumination optical path, then numerical aperture $NA_i$ of the illumination optical system becomes larger than when aperture stop 140f was set in the illumination optical path. At this point, the image of aperture stop 140g having aperture diameter $D_{140g}$ is formed inside projection lens 21 having aperture diameter $D_{110}$, and the $\sigma$ value is set to 0.8. In other words, the relation $\sigma = D_{140g}/D_{110} = NA_i/NA_p = 0.8$ is established. Accordingly, if aperture stop 140g is set inside the illumination optical path, the pattern of reticle 20 can be transferred onto workpiece (wafer) 22 based on a $\sigma$ value of 0.8.

Furthermore, if aperture stop 140h, having a circular aperture larger than aperture stop 140g, is set in the illumination optical path, then numerical aperture

$NA_i$ of the illumination optical system becomes larger than when aperture stop 140g was set in the illumination optical path. At this point, the image of aperture stop 140h, having aperture diameter $D_{140h}$ the same size as the aperture diameter $D_{110}$ of aperture stop 110, is formed, and the a value is set to 1.0. In other words, the relation $a = D_{140h}/D_{110} = NA_i/NA_p = 1.0$ is established. Accordingly, if aperture stop 140h is set in the illumination optical path, the illumination light beam is sufficiently guided as far as the effective diameter of the optical elements like lenses comprising condenser optical system 19 of the illumination optical system, the effective diameter of optical elements like lenses comprising projection lens 21, and as far as the part beyond the effective diameters of these optical elements. Consequently, moisture and organic matter and the like adhering to the surfaces of these optical elements can be eliminated by the photo-cleaning effect due to the exposure illumination light beam.

In addition, if aperture stop 140a, having a circular aperture larger than aperture stop 140h, is set in the illumination optical path, then numerical aperture $NA_i$ of the illumination optical system becomes larger than when aperture stop 140h was set in the illumination optical path At this point, the image of aperture stop 140a having aperture diameter $D_{140a}$ is formed so that it includes aperture stop 110a having aperture diameter $D_{110}$, and the σ value is set to 1.2. In other words, the relation $σ = D_{140a}/D_{110} = NA_i/NA_p = 1.2$ is established. Accordingly, if aperture stop 140a is set in the illumination optical path, the illumination light beam is sufficiently guided as far as the effective diameter of the optical elements like lenses comprising condenser optical system 19 of the illumination optical system, the effective diameter of optical elements like lenses comprising projection lens 21, naturally, and as far as the lens circumference part beyond the effective diameters of these optical elements. Consequently, an effect can be sufficiently obtained wherein moisture and organic matter and the like adhering to the surfaces of these optical elements is photo-cleaned.

Next, the operation of the present example is explained. First, it became apparent through various experiments that, as shown in FIG. 11, the transmittance of the optical system part of the projection exposure apparatus drops if the illumination light beam as the exposure light is not guided to the optical system part of the projection exposure apparatus, even in a state in which chamber 102 is filled with an inert gas like dried nitrogen and isolated from the atmosphere. Consequently, when performing the photolithography process to manufacture a semiconductor device, Step 1 is executed wherein the transmittance of the optical system part of the projection exposure apparatus 100 (i.e., reflective mirror 42 of the illumination optical system, condenser optical system 19, projection lens 21 and the like) is verified by the transmittance measurement system before starting up projection exposure apparatus shown in FIG. 1 and proceeding to the exposure operation. Furthermore, the phenomenon wherein the transmittance of transmissive optical elements like condenser optical system 19 and projection lens 21 drops appears if the phenomenon wherein the reflectance of reflective optical elements like reflective mirror 18 and the like is reduced.

First, in Step 1, if projection exposure apparatus 100 transitions to a start-up state via a power supply (not shown) and light from light sources 10 is from an ArF excimer laser, and reticle 20 is not present, control system 27 sets second detector 24, provided at one end of workpiece (wafer) stage 23, in the exposure plane of projection lens 21 via drive system 109.

Next, control system 27 discriminates, based on the output from first detector 44b provided below reflective mirror 42 together with the output from second detector 24 provide at one end of workpiece (wafer) stage 23, whether the light transmittance of a predetermined optical system part of projection exposure apparatus 100 has reached a predetermined value. In other words, the divider unit inside control system 27 calculates the ratio of both outputs based on the output from first detector 4 and the output from second detector 12. Subsequently, the discrimination unit inside control system 27 discriminates, based on the calculation results thereof, whether the output from the divider unit has reached a predetermined threshold value. If the output from the divider unit has not reached a predetermined threshold value, operation transitions to Step 3 as the exposure operation discussed later, by means of this discrimination unit. If the output from the divider unit has reached the predetermined threshold value, operation proceeds to the next Step 2 as the photo-cleaning process, by means of this discrimination unit.

Furthermore, in Step 1, it is preferable that control system 27 discriminates, based on the output from second detector 24 provided at one end of workpiece (wafer) stage 23, together with the output from third detector 112 provided at one end of reticle stage 107, whether the light transmittance of projection lens 21 of projection exposure apparatus 100 has reached a predetermined value, and judges whether to proceed to Step 2 after further including the discrimination results related to the light transmittance of projection lens 21. At this point, in order to obtain the output from third detector 112, it is necessary that control system 27 set third detector 112, provided at one end of reticle stage 107, in the plane wherein the reticle should preferably be arranged.

In Step 2, to execute the photo-cleaning process, control system 27 first sets the aperture size of variable aperture stop 14 via drive system 146. Accordingly, control system 27 rotates turret plate 140 via drive system 146, and sets an appropriate aperture stop, 140a or 140h, in the illumination optical path so that the σ value is 1 or greater.

To paraphrase, control system 27 rotates turret plate 140 via drive system 146 and sets an appropriate aperture stop, 140a or 140h, in the illumination optical path so that the following relation is satisfied:

$$NA_i \geq NA_p.$$

Consequently, an illumination light beam is sufficiently guided as far as the effective diameter of the optical elements like lenses comprising condenser optical system 19 of the illumination optical system, the effective diameter of the optical elements like lenses comprising projection lens 21 and, further, the part beyond the effective diameters of these optical elements. As a result, moisture and organic matter and the like adhering to the surfaces of these optical elements can be eliminated by the photo-cleaning effect due to the exposure illumination light beam.

In addition, there is a possibility that the moisture and organic matter and the like that separated from the surfaces of optical elements by means of the photo-cleaning effect due to the irradiation of the exposure illumination light beam may be suspended in chamber 102 or in a predetermined plurality of spaces formed between a plurality of optical elements. Consequently, control system 27 operates gas supply apparatus 120 together with gas discharge apparatus 130 to forcibly discharge to outside the apparatus moisture and organic matter and the like that separated from the surfaces of optical elements. In other words, based on a command from control system 27, gas supply apparatus 120 supplies inert gas like newly dried nitrogen into chamber 102 through pipe 122 and inside projection lens 21 through pipe 124, respectively. Simultaneous therewith, gas discharge apparatus 130, based on a command from control system 27, discharges to outside of projection exposure apparatus 100 the inert gas that includes moisture and organic matter and the like inside chamber 102 through pipe 132, and the inert gas that includes moisture and organic matter and the like inside projection lens 21 through pipe 134.

Based thereon, since chamber 102 and projection lens 21 are filled with inert gas like nitrogen that has been cleaned by eliminating moisture and organic matter and the like, the transmittance of the optical system part of the projection exposure apparatus can be restored to its original state. Furthermore, although inert gas like newly dried nitrogen is supplied respectively into chamber 102 as well as projection lens 21 by gas supply apparatus 120 during the photo-cleaning process of Step 2, it is preferable to adopt a configuration wherein a strong oxidizing gas like oxygen ($O_2$), ozone ($O_3$) or active oxygen ($O^*$) is mixed into the inert gas like nitrogen to be supplied. As a result, the photo-cleaning effect is accelerated by the action of the strong oxidizing gas, and a larger effect can be expected. Also, at the same time as the transition from the exposure process of Step 1 to the photo-cleaning process of Step 2, air is flowed into at least one of chamber 102 or projection lens 21.

Subsequently, the photo-cleaning process of Step 2 can be started in an air environment, and can be gradually replaced by the inert gas.

When the photo-cleaning process of Step 2 is completed, operation transitions to the exposure operation as the third step. In Step 3, the actual exposure operation is executed. First, when reticle 20 is set on reticle stage 107 (namely the pattern surface of reticle 20 is set in the object plane of projection lens 21), control system 27 sets the exposure surface 22s of workpiece (wafer) 22, supported by workpiece (wafer) stage 23 via drive system 109, in the image plane of projection lens 21. Simultaneous therewith, control system 27 sets the aperture size of variable aperture 14 via drive system 146.

Accordingly, the exposure conditions, like the a value, and the exposure map, in accordance with which workpiece (wafer) 22 to be exposed is sequentially carried with each exposure completion, are pre-input into the memory unit (not shown) inside control system 27 via input system 160, which may be a console. Based on this input information, control system 27 rotates turret plate 140 via drive system 146, and sets one desired aperture stop from among the six aperture stops 140b to 140g for exposure. Based thereon, the pattern of reticle 20 under the condition of the desired σ value can be transferred onto workplece (wafer) 22 in a state wherein the transmittance of a predetermined optical system of the projection exposure apparatus is restored. As a result, a satisfactory microscopic pattern image can be faithfully transferred onto workpiece (wafer) 22 and highly integrated satisfactory semiconductor devices can be manufactured with high throughput.

Furthermore, even if the exposure operation of the above Step 3 is executed, there are cases where contaminants like moisture and organic matter adhere inside chamber 102 and projection lens 21, reducing the transmittance of the optical system in the projection exposure apparatus 100.

Consequently, if n is given as an integer I or greater, the exposure operation is first stopped, operation returns to Step 1 and the transmittance is measured after the exposure is completed of the $n^{th}$ photosensitive substrate since the start of exposure and before the exposure of the $n+1^{th}$ photosensitive substrate is executed. For example, operation returns to the transmittance measurement process of Step 1 in a periodic step every time the exposure of 300 - 500 workpiece (wafers) 22 is completed. Then, control system 27 again confirms the transmittance of a predetermined optical system part of projection exposure apparatus 100 (reflective mirror 18 of the illumination optical system, condenser optical system 19 and projection lens 21 and the like) by means of the transmittance measurement system.

If a drop in the transmittance of a predetermined optical system part of the projection exposure apparatus is not confirmed, operation returns again to Step 3 and the exposure operation continues. If a drop in the transmittance of a predetermined optical system part of the projection exposure apparatus is confirmed, operation returns again to Step 2 and the photo-cleaning process is executed.

As can be understood from the above, since the illumination light beam is guided as far as a part beyond the effective diameter of each optical element of the optical system during exposure, it is preferable to change the numerical aperture of the illumination optical system so that the condition $NA_{i1} > NA_{i2}$ in the present example is satisfied, wherein $NA_{i1}$ is the numerical aperture of the illumination optical system in the photo-cleaning process of the abovementioned Step 2, and $NA_{i2}$ is the numerical aperture of the illumination optical system in the exposure process of the abovementioned Step 2.

Furthermore, since the illumination light beam is more reliably and sufficiently guided as far as the part beyond the effective diameter of each optical element of the optical system during exposure, it is preferable to change the numerical aperture of the illumination optical system so that the condition $NA_{i1} \geq NA_p$ (in other words, the condition of $\sigma \geq 1$) is satisfied.

Furthermore, in the example discussed above, the fact that the $\sigma$ value in the photo-cleaning process is set to 1 or above was mentioned. However, the present invention is not limited thereto, and the numerical aperture of the illumination optical system in the photo-cleaning process may be set so that the maximum $\sigma$ value is larger than the maximum $\sigma$ value during the exposure operation. In this case, in order to obtain a more satisfactory photo-cleaning effect, it is preferable to satisfy the following relation:

$$NA_i \geq 0.85 NA_p \text{ or } NA_{i1} \geq 0.85 NA_p$$

In addition, in the example discussed above, if photo-cleaning is performed in the photo-cleaning process using a reticle for photo-cleaning having a predetermined pattern like a diffractive grating, a greater photo-cleaning effect can be expected, since the light due to the diffracted light of the reticle for photo-cleaning and the like can be guided throughout the optical system.

The above working example discussed the case wherein projection lens 21 completely comprised refractive optical elements. However, the present invention is not limited thereto, and may comprise a catadioptric-type projection optical system that includes refractive-type optical elements like lenses and reflective-type optical elements like mirrors. Furthermore, projection lens 21 may also mostly or completely comprise reflective-type optical elements like mirrors. If projection lens 21 comprises mainly reflective-type optical elements like mirrors, the measurement of the reflectance of the optical system predominates over the transmittance of the optical system, but is still included in the concept of the present invention wherein the transmittance of the optical system is measured. Furthermore, since the wavelength of the light recognized as necessary for photo-cleaning is a short wavelength under 200 nm, it is extremely effective to provide a photo-cleaning function in an exposure apparatus that exposes with a light source having a short wavelength under 200 nm.

Next, an example related to a method for manufacturing a projection lens for a projection exposure apparatus will be explained.

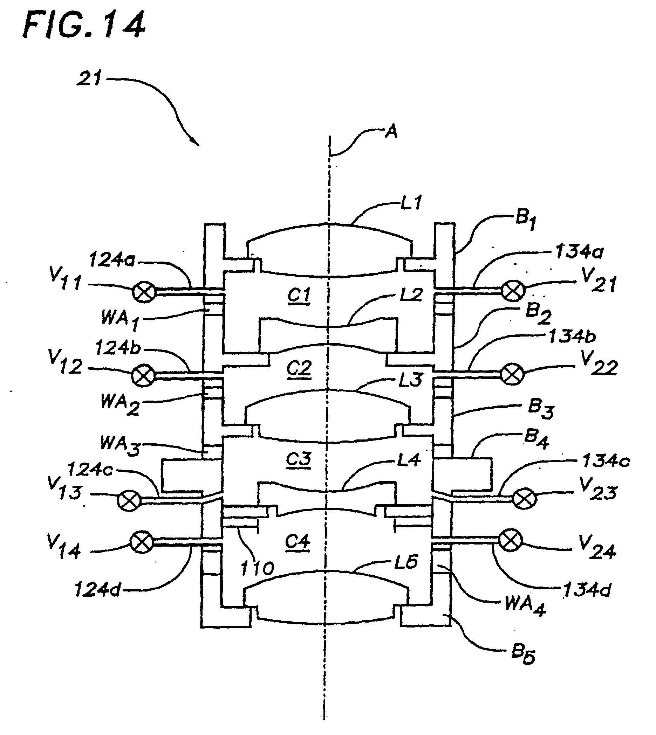

In Step 1, lens elements $L_1$ - $L_5$ as the optical elements comprising the projection optical system in accordance with design values like predetermined lens data, and lens barrels $B_1$ - $B_5$ that support the lens elements are manufactured, as shown in FIG. 14. Specifically, lens elements $L_1$ - $L_5$ are first fabricated using well-known lens fabrication machines so that they have a radius of curvature and on-axis thickness in accordance with the predetermined design values respectively based on predetermined optical materials. Subsequently, an antireflection film is formed on the surfaces of the fabricated lens elements $L_1$ - $L_5$ in order to efficiently transmit light of the exposure wavelength (hereafter, light of 193 nm) by means like well-known vapor deposition apparatuses. Lens barrels $B_1$ - $B_5$ that support the lens elements are fabricated using well-known metalworking machines to a shape having predetermined dimensions respectively based on the predetermined materials (stainless steel and brass and the like). In addition, through-holes for injecting and discharging inert gas like nitrogen are fabricated in predetermined lens barrels $B_1$ - $B_5$, by means of metalworking machines.

When the manufacture of parts comprising projection lens 21 is completed, as described above, operation transitions to the projection lens 21 assembly process in Step 2. In Step 2, Lens elements $L_1$-$L_5$ manufactured in Step 1 are assembled in lens barrels $B_1$-$B_5$ manufactured in the same Step 1, as shown in FIG. 14, and five divided lens barrel units are manufactured. Furthermore, at this point, injection pipes 124a -124d, to which injection side valves $V_{11}$ - $V_{14}$ are attached, and discharge pipes 134a-134d, to which discharge side valves $V_{21}$-$V_{24}$ are attached, are attached to numerous through holes formed in predetermined five lens barrels $B_1$ - $B_5$.

As shown in FIG. 14, when the manufacture of the above five divided lens barrel units is completed, assembly of the divided lens barrel units is completed by ordering and adjusting each divided lens barrel unit while interposing washers $WA_1$ - $WA_4$. Then, after the projection optical system is assembled, in order to confirm the optical performance thereof, a test pattern (not shown) is arranged at the object plane (not shown) of projection lens 21, for example, and the test pattern image (not shown) formed at the image plane (not shown) of projection lens 21 is observed through a television camera (not shown). When the assembly process of projection lens 21 in the above Step 2 is completed, operation transitions to the photo-cleaning process.

The work in the above Step 1 and Step 2 must basically be performed in the atmosphere (air). In such an environment, moisture and organic matter contained in the atmosphere adheres to the surfaces of lens elements $L_1$ - $L_5$, resulting in greatly decreasing the transmittance of the assembled projection lens 21.

Accordingly, in Step 3, projection lens 21 assembled in Step 2 is irradiated with light of a wavelength the same as the exposure light, and the moisture and organic matter adhering to the surfaces of the lens elements comprising projection lens 21 are eliminated. Furthermore, since the wavelength of light recognized as necessary to perform photo-cleaning is a short wavelength under 200 nm, it is effective to use the photo-cleaning process when manufacturing a projection optical system for an exposure apparatus that exposes with light of a short wavelength under 200 nm.

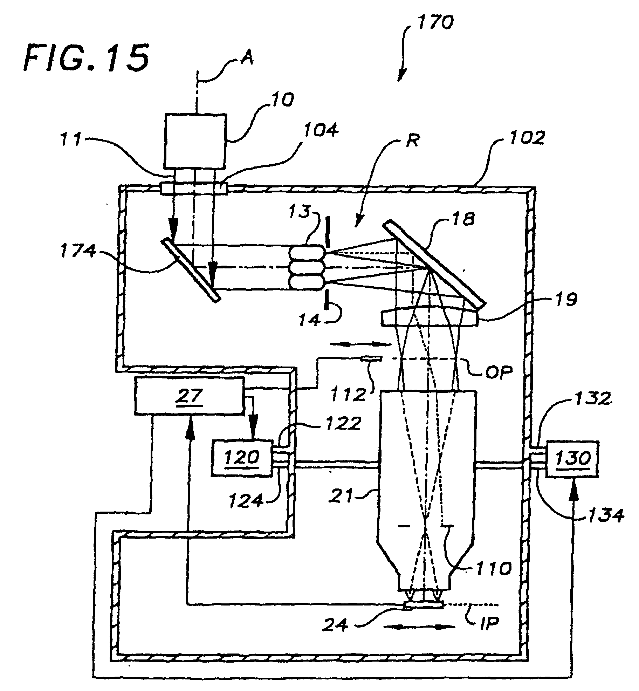

FIG. 15 shows a schematic block diagram of photo-cleaning apparatus 170 for irradiating projection lens 21 assembled in Step 2 with light of a wavelength the same as the exposure light. In FIG. 15, components having the same function in projection exposure apparatus 100 of FIG. 11 are assigned the same symbols. As shown in FIG. 15, projection lens 21 assembled in Step 2 is first mounted inside chamber 102 of the photo-cleaning apparatus. In other words, projection lens 21 is mounted so that the object plane of projection lens 21 coincides with surface to be irradiated at the rear focal position of condenser optical system 19 in the illumination optical system. Next, four injection pipes 124a -124d, to which injection valves $V_{11}$ - $V_{14}$ are attached, as shown in FIG. 14, are connected to injection pipe 124 shown in FIG. 15. In addition, four discharge pipes 134a - I 34d to which discharge valves $V_{21}$ - $V_{24}$ are attached, are connected to discharge pipe 134 shown in FIG. 15. When the above setup is completed, as shown in FIG. 15, control system 27 operates gas supply apparatus 120 and gas discharge apparatus 130. Inert gas like dried nitrogen is respectively supplied into chamber 102 and projection lens 21 by means of gas supply apparatus 120. The air inside chamber 102 and projection lens 21 is discharged by means of gas discharge apparatus 130. Then, the inert gas inside chamber 102 and projection lens 21 is replaced with air.

When chamber 102 and projection lens 21 are sufficiently filled with inert gas, ArF excimer laser light from light source 10, that oscillates pulsed light having an output wavelength equal to the exposure wavelength (for example, 193 nm) is guided to the photo-cleaning apparatus 170 through window 104. The laser light passing through light transmitting window 104 is reflected by reflective mirror 174, guided to fly's-eye lens 13 (i.e., optical integrator 13) and forms numerous light sources (secondary light sources) on the exit surface side of fly's-eye lens 13.

Aperture stop 14 having a circular aperture of a predetermined size is provided at the position wherein the numerous secondary light sources formed by this fly's-eye lens 13 are formed. Aperture stop 14 is constituted so that it satisfies the condition $NA_{i1} \geq NA_p$ (namely, the condition of $\sigma \geq 1$), wherein $NA_{i1}$ is the numerical aperture of the illumination optical system in the present process (photo-cleaning process).

After the light beam from the numerous secondary light sources is reflected by reflective mirror 18, it is condensed by condenser optical system 19 and superimposingly and evenly illuminates the surface to be irradiated. The light beam that passed through this surface to be irradiated passes through projection lens 21. By means thereof, moisture and organic matter and the like adhering to the surface of the plurality of optical elements $L_1$ - $L_5$ comprising projection lens 21 can be eliminated by the photo-cleaning effect due to the exposure illumination light beam.

Due to the photo-cleaning effect owing to the irradiation of the above exposure illumination light beam, there is a possibility that moisture and organic matter and the like that separated from the surfaces of the plurality of optical elements $L_1$ - $L_5$ comprising projection lens 21 may be suspended in chamber 102 or in the predetermined plurality of spaces formed between the plurality of optical elements. Consequently, control system 27 operates, simultaneous with the execution of the photo-cleaning process, gas supply apparatus 120 and gas discharge apparatus 130 to forcibly discharge to outside the apparatus the moisture and organic matter and the like that separated from the surfaces of the optical elements. In other words, based on a command from control system 27, gas supply apparatus 120 supplies inert gas like newly dried nitrogen into chamber 102 through pipe 122 and into projection lens 21 through pipe 124, respectively. Simultaneous therewith, based on a command from control system 27, gas discharge apparatus 130 discharges to outside the projection exposure apparatus the inert gas that includes the moisture and organic matter and the like inside chamber 102 through pipe 132, and the inert gas that includes the moisture and organic matter and the like inside projection lens 21 through pipe 134.

As a result, since chamber 102 and projection lens 21 are filled with inert gas like nitrogen that has been cleaned by eliminating moisture and organic matter and the like, it is possible to restore the transmittance of projection lens 21 to its original condition.

Furthermore, when performing the photo-cleaning process of Step 3, inert gas like newly dried nitrogen is supplied by gas supply apparatus 120 into chamber 102 and projection lens 21, respectively. However, it is preferable to mix a strong oxidizing gas like oxygen ($O_2$), ozone ($O_3$) or active oxygen ($O^*$) into the inert gas like the nitrogen supplied by gas supply apparatus 120. As a result, the photo-cleaning effect is accelerated due to the action of the strongly oxidizing gas, and a greater effect can be expected.

In addition, it is preferable to measure the transmittance of projection lens 21 before and after executing the photo-cleaning process of Step 3. In this case, moveable third detector 112 is arranged along the surface to be irradiated of the illumination optical system, and moveable second detector 24 is arranged along the image plane of projection lens 21. When measuring the transmittance of projection lens 21, third detector 112 is set in the surface to be irradiated, and second detector 24 is set in the image plane of projection lens 21.

Then, control system 27 may be constituted so that, based on the output from third detector 112 and the output from second detector 24, it discriminates whether the light transmittance of projection lens 21 has reached a predetermined value. Consequently, if the light transmittance of projection lens 21 is measured before executing the photo-cleaning process of Step 3, how long the ArF excimer laser light from light source 10 should be irradiated can be estimated. In addition, if the transmittance of projection lens 21 is measured after executing the photo-cleaning process of Step 3, the restoration status of the light transmittance of projection lens 21 can be confirmed.

If it is necessary to readjust projection lens 21 at the stage where the photo-cleaning process of the above Step 3 has completed, projection lens 21 is removed from chamber 102 of projection exposure apparatus 170 in FIG. 15 and the operation returns to Step 2. In addition, if it is confirmed at the completion of Step 3 that a sufficient image formation performance for projection lens 21 was obtained in the abovementioned Step 1, the projection exposure apparatus is completed by removing the projection optical system from chamber 104 of the photo-cleaning apparatus in FIG. 5, and attaching it to the optical exposure apparatus body as shown in FIG. 1.

With respect to the embodiment as shown in FIG. 11 and FIG. 15, when the projection lens 21 has only a plurality of optical mirrors (e.g., plane mirror, concave mirror or convex mirror), it is possible that the control system 27 detects a reflectance of the projection optical system 21 based upon output signals from second and third detectors 24 and 112. Further with respect to the embodiment as shown in FIG. 11 and FIG. 15, when the illumination optical system has only a plurality of optical mirrors (e.g., plane mirror, concave mirror or convex mirror), it is possible that the control system 27 detects a reflectance of the illumination optical system based upon the output signal from second detector 24.

To summarize, according to the present invention as described above, since moisture and organic matter and the like adhering to the optical system comprising the projection exposure apparatus can be eliminated by means of photo-cleaning, a satisfactory reticle pattern image can be transferred onto a photosensitive substrate. Moreover, even if the transmittance of the projection optical system drops in a photolithography process that includes an exposure method, since the transmittance of the projection optical system can be sufficiently restored by newly adopting a photo-cleaning process, semiconductor devices like LSIs having a higher level of integration can be manufactured since a finer pattern can be transferred onto photosensitive substrate. In addition, if the photo-cleaning process according to the present invention is used when manufacturing the projection optical system, it becomes possible to perform assembly and adjustment work of the projection optical system in a normal working environment, and the transmittance of the projection optical system can be sufficiently ensured.

The above-described embodiments are meant to clarify the technical details of the present invention. For instance, the optical components are described and shown in the figures as single elements, whereas in practice one skilled in the art will know that such components may include multiple elements. In addition, the above-described embodiments can be combined (e.g., the oscillating lens embodiment can be employed in optical exposure apparatus 5 with certain obvious modifications) to create other optical exposure apparatuses with photo-cleaning capability. Thus, since certain changes may be made to the apparatuses and methods disclosed herein with respect to the to the aforementioned preferred embodiments without departing from the scope of the invention, it is intended that all matter contained in the above description and shown in the accompanying drawings be interpreted in an illustrative and not in a limiting sense.

**Claims**

1. An optical exposure apparatus (5; 40; 50; 55; 65; 70; 75; 80; 85; 100; 170) comprising:

    a) a light source (10) emitting light of a predetermined wavelength;
    b) an optical system comprising a plurality of optical elements (15a, 15b, 17, 18, 19, 20, 21) for exposing a photosensitive substrate (22) with said light of said predetermined wavelength; and
    c) a photo-cleaning unit (30) for improving one of (i) transmittance and (ii) reflectance of at least one of said plurality of optical elements (15a, 15b, 17, 18, 19, 20, 21);

    wherein the photo-cleaning unit (30) is adapted to optically clean a surface of said at least one of said plurality of optical elements (15a, 15b, 17, 18, 19, 20, 21) by means of said light of said predetermined wavelength guided by said at least one of said plurality of optical elements (15a, 15b, 17, 18, 19, 20, 21) of said optical system.

2. An optical exposure apparatus (5; 40; 50; 55; 65; 70; 75; 80; 85; 100; 170) according to claim 1, wherein said photo-cleaning unit (30) is disposed between said light source (10) and said photosensitive substrate (22) to be exposed.

3. An optical exposure apparatus (5; 40; 50; 55; 65; 70; 75; 80; 85; 100; 170) according to claim 1, wherein said optical system is disposed between said light source (10) and said photo-cleaning unit (30).

4. An optical exposure apparatus (5; 40; 50; 55; 65; 70; 75; 80; 85; 100; 170) according to any of the claims 1 to 3, further comprising:

   a) a measuring system (24, 26, 34, 36; 42, 44a, 44b) for measuring said one of (i) said transmittance and (ii) said reflectance of said at least one of said plurality of optical elements (15a, 15b, 17, 18, 19, 20, 21) ; and
   b) a control system (27, 32) connected to said photo-cleaning unit (30) and said measuring system (24, 26, 34, 36; 42, 44a, 44b) for changing said photo-cleaning unit (30).

5. An optical exposure apparatus (5; 40; 50; 55; 65; 70; 75; 80; 85; 100; 170) according to any of the claims 1 to 4, wherein said optical system includes an illumination optical system (10, 14, 15a, 15b, 16, 17, 18, 19).

6. An optical exposure apparatus (5; 40; 50; 55; 65; 70; 75; 80; 85; 100; 170) according to any of the claims 1 to 4, wherein said optical system includes an illumination optical system (10, 14, 15a, 15b, 16, 17, 18, 19) and a projection optical system (21).

7. An optical exposure apparatus (5; 40; 50; 55; 65; 70; 75; 80; 85; 100; 170) according to any of the claims 1 to 6, further comprising:

   A) a reticle (20) having a pattern, said reticle (20) being disposed adjacent said illumination optical system (10, 14, 15a, 15b, 16, 17, 18, 19);
   B) a variable aperture (14, 16) for controlling a numerical aperture of said illumination optical system (10, 14, 15a, 15b, 16, 17, 18; 19);
   C) a transmittance measurement system (24, 26);
   D) a light beam (11); and
   E) a control system (27, 32) connected to said transmittance measurement system (24, 26) and said variable aperture (14, 16) for changing said variable aperture (14, 16) so as to change said numerical aperture;

   wherein

   a) said variable aperture (14, 16) being part of said illumination optical system (10, 14, 15a, 15b, 16, 17, 18, 19);
   b) said illumination optical system (10, 14, 15a, 15b, 16, 17, 18, 19) comprises said variable aperture (14, 16) and having an illumination optical system transmittance;
   c) said projection optical system (21) is disposed adjacent said reticle (20) and opposite said illumination optical system (10, 14, 15a, 15b, 16, 17, 18, 19), and adjacent a photosensitive substrate (22), and has a projection lens transmittance; and
   d) said transmittance measurement system (24, 26) measures at least one of said illumination optical system transmittance and said projection lens transmittance.

8. An optical exposure apparatus (5; 40; 50; 55; 65; 70; 75; 80; 85; 100; 170) according to any of the claims 1 to 7, wherein said illumination optical system (10, 14, 15a, 15b, 16, 17, 18, 19) has a numerical aperture $NA_i$, said projection optical system (21) has a numerical aperture $NA_p$ and wherein said photo-cleaning unit (30) acts to satisfy the condition

$$NA_i \geq NA_p.$$

9. A method of fabricating semiconductor devices comprising the steps of:

   a) providing an optical system having a plurality of optical elements (15a, 15b, 17, 18, 19, 20, 21) so as to expose a reticle (20) with a pattern onto a photosensitive substrate (22);
   b) photo-cleaning of at least one of said plurality of optical elements (15a, 15b, 17, 18, 19, 20, 21), thereby increasing one of (i) transmittance and (ii) reflectance of said at least one of said plurality of optical elements (15a, 15b, 17, 18, 19, 20, 21) by means of guiding light of a predetermined wavelength guided by said at least one of said plurality of optical elements (15a, 15b, 17, 18, 19, 20, 21) of said optical system; and
   c) exposing said reticle pattern onto said photosensitive substrate (22) using said optical system.

10. A method according to claim 9, further comprising the step of:

   d) measuring said one of (i) transmittance and (ii) reflectance of said at least one of said plurality of optical elements (15a, 15b, 17, 18, 19, 20, 21).

11. A method according to claim 10, further comprising the step of determining whether at least one of said step b) and said step c) is carried out or step c) is carried out, based on said step d).

12. A method according to any of the claims 9 to 11, wherein:

> A) step c) is performed n times ($n \geq 0$) by illuminating said pattern on said reticle (20) with light generated from an illumination optical system which is comprised in said plurality of optical elements (15a, 15b, 17, 18, 19, 20, 21) and projecting an image of said pattern through a projection optical system (21) which is comprised in said plurality of optical elements (15a, 15b, 17, 18, 19, 20, 21), said projection optical system (21) having a projection optical system transmittance; and
> B) step b) is performed after performing n exposures before performing an n+1 exposure by irradiating said projection optical system (21) with said light from said illumination optical system so as to improve said projection optical system transmittance to restore an optimum transmittance of said projection optical system (21).

13. A method according to any of the claims 9 to 12, further including the step of:

> e) controlling said optical system so that it has a numerical aperture $NA_{i1}$ in said step b) during said irradiating process, and a numerical aperture $NA_{i2}$ in said step c) while exposure process carries- out, and so that

$$NA_{i1} \geq NA_{i2}.$$

14. A method according to any of the claims 9 to 13, wherein said optical system comprises a projection optical system (21) having a numerical aperture $NA_p$ and an illumination optical system (10, 14, 15a, 15b, 16, 17, 18, 19) having a numerical aperture $NA_{i1}$, and wherein in said step b) irradiation process is performed so as to satisfy the condition

$$NA_{i1} \geq NA_p.$$

15. A method according to any of the claims 9 to 11, wherein said optical system comprising a projection optical system (21) having a plurality of optical components (L1, L2, L3, L4, L5) with a plurality of spaces (C1, C2, C3, C4) there between, and further comprising the step of injecting an inert gas into said plurality of spaces (C1, C2, C3, C4) of said projection optical system (21), and then discharging said inert gas from said plurality of spaces (C1, C2, C3, C4).

16. A method according to any of the claims 9 to 14, further comprising the step of injecting a predetermined gas into said optical system (13, 14, 18, 19, 20, 21).

17. A method according to claim 16, further comprising the step of discharging the predetermined gas from said optical system (13, 14, 18, 19, 20, 21).

18. A method according to claim 16 or 17, wherein the predetermined gas comprises an inert gas.

19. An optical exposure apparatus (5; 40; 50; 55; 65; 70; 75; 80; 85; 100; 170) according to claim 7, further comprising a discharging unit (130) for discharging the predetermined gas from said optical system.

20. An optical exposure apparatus (5; 40; 50; 55; 65; 70; 75; 80; 85; 100; 170) according to claim 19, wherein the predetermined gas comprises an inert gas.

21. An optical exposure apparatus (5; 40; 50; 55; 65; 70; 75; 80; 85; 100; 170) according to any of the claims 1 to 7 and 19 and 20, wherein said photo-cleaning unit (30) includes a photo-cleaning member (72) disposed at a position where a reticle (20) with a predetermined pattern is placed.

22. An optical exposure apparatus (5; 40; 50; 55; 65; 70; 75; 80; 85; 100; 170) according to any of the claims 1 to 7 and 19 to 21, wherein said optical system includes a beam changing unit (14) for changing a beam from said light source (10) into an annular beam and for changing an annular ratio of the annular beam.

23. An optical exposure apparatus (5; 40; 50; 55; 65; 70; 75; 80; 85; 100; 170) according to any of the claims 1 to 7 and 19 to 21, wherein said optical system includes a beam changing unit (14) for changing a beam from said light source (10) into multi off-centered beams.

24. An optical exposure apparatus (5; 40; 50; 55; 65; 70; 75; 80; 85; 100; 170) according to any of the claims 1 to 7 and 19 to 23, wherein the wavelength of said light from said light source (10) is less than 200 nanometers.

25. A method according to any of the claims 9 to 18, wherein said step b) includes the step of using an exposure light with said- predetermined wavelength used in step c).

**26.** A method according to any of the claims 9 to 18 and 25, wherein said step c) further includes the step of using a beam changing unit (14) comprised in said optical system so as to change a beam from said light source (10) into an annular beam and to change an annular ratio of the annular beam.

**27.** A method according to any of the claims 9 to 18 and 25, wherein said step c) further includes the step of using a beam changing unit (14) comprised in said optical system so as to change a beam from said light source (10) into multi off-centered beams.

**28.** A method according to any of the claims 9 to 18 and 25 to 27, wherein the wavelength of said light used in said step b) and said step c) is less than 200 nanometers.

**Patentansprüche**

**1.** Optischer Belichtungsapparat (5; 40; 50; 55; 65; 70; 75; 80; 85; 100; 170) aufweisend:

a) eine Licht einer vorgegebenen Wellenlänge emittierende Lichtquelle (10) ;
b) ein optisches System aufweisend eine Mehrzahl optischer Elemente (15a, 15b, 17, 18, 19, 20, 21) zum Belichten eines photosensitiven Substrates (22) mit dem Licht der vorgegebenen Wellenlänge; und
c) eine photo-reinigende Einheit (30) zum Verbessern entweder (i) des Transmissionsgrades oder (ii) des Reflexionsgrades von mindestens einem der Mehrzahl optischer Elemente (15a, 15b, 17, 18, 19, 20, 21);

wobei die photo-reinigende Einheit (30) eingerichtet ist zum optischen Reinigen einer Oberfläche des mindestens einen der Mehrzahl optischer Elemente (15a, 15b, 17, 18, 19, 20, 21) mittels des von dem mindestens einen der Mehrzahl optischer Elemente (15a, 15b, 17, 18, 19, 20, 21) geleiteten Lichts der vorgegebenen Wellenlänge.

**2.** Optischer Belichtungsapparat (5; 40; 50; 55; 65; 70; 75; 80; 85; 100; 170) gemäß Anspruch 1, bei dem die photo-reinigende Einheit (30) zwischen der Lichtquelle (10) und dem photosensitiven Substrat (22) angeordnet ist.

**3.** Optischer Belichtungsapparat (5; 40; 50; 55; 65; 70; 75; 80; 85; 100; 170) gemäß Anspruch 1, bei dem das optische System zwischen der Lichtquelle (10) und der photo-reinigenden Einheit (30) angeordnet ist.

**4.** Optischer Belichtungsapparat (5; 40; 50; 55; 65; 70; 75; 80; 85; 100; 170) gemäß einem der Ansprüche 1 bis 3, ferner aufweisend:

a) ein Messsystem (24, 26, 34, 36; 42, 44a, 44b) zum Messen entweder (i) des Transmissionsgrades oder (ii) des Reflexionsgrades des mindestens einen der Mehrzahl optischer Elemente (15a, 15b, 17, 18, 19, 20, 21); und
b) ein mit der photo-reinigenden Einheit (30) und dem Messsystem (24, 26, 34, 36; 42, 44a, 44b) verbundenes Steuersystem (27, 32) zum Verändern der photo-reinigenden Einheit (30).

**5.** Optischer Belichtungsapparat (5; 40; 50; 55; 65; 70; 75; 80; 85; 100; 170) gemäß einem der Ansprüche 1 bis 4, bei dem das optische System ein optisches Illuminationssystem (10, 14, 15a, 15b, 16, 17, 18, 19) aufweist.

**6.** Optischer Belichtungsapparat (5; 40; 50; 55; 65; 70; 75; 80; 85; 100; 170) gemäß einem der Ansprüche 1 bis 4, bei dem das optische System ein optisches Illuminationssystem (10, 14, 15a, 15b, 16, 17, 18, 19) und ein optisches Projektionssystem (21) aufweist.

**7.** Optischer Belichtungsapparat (5; 40; 50; 55; 65; 70; 75; 80; 85; 100; 170) gemäß einem der Ansprüche 1 bis 6, ferner aufweisend:

A) eine Strichplatte (20) mit einem Muster, wobei die Strichplatte (20) benachbart zu dem optischen Illuminationssystem (10, 14, 15a, 15b, 16, 17, 18, 19) angeordnet ist;
B) eine variable Blende (14, 16) zum Steuern einer numerischen Apertur des optischen Illuminationssystems (10, 14, 15a, 15b, 16, 17, 18, 19);
C) ein Transmissionsgrad-Messsystem (24, 26);
D) einen Lichtstrahl (11); und
E) ein mit dem Transmissionsgrad-Messsystem (24, 26) und der variablen Blende (14, 16) verbundenes Steuersystem (27, 32) zum Verändern der variablen Blende (14, 16), um so die numerische Apertur zu verändern;

wobei

a) die variable Blende (14, 16) Teil des optischen Illuminationssystems (10, 14, 15a, 15b, 16, 17, 18, 19) ist;
b) das optische Illuminationssystem (10, 14, 15a, 15b, 16, 17, 18, 19) die variable Blende (14, 16) aufweist und einen optisches Illuminationssystem-Transmissionsgrad hat;
c) das optische Projektionssystem (21) benachbart zu der Strichplatte (20) und gegenüberliegend dem optischen Illuminationssystem (10, 14, 15a, 15b, 16, 17, 18, 19) sowie benachbart zu einem photosensitiven Substrat (22) angeordnet ist und einen Projektionslinsen-Transmissionsgrad hat; und
d) das Transmissionsgrad-Messsystem (24, 26) zumindest einen von dem optisches Illuminationssystem-Transmissionsgrad und dem Projektionslinsen-Transmissionsgrad misst.

8. Optischer Belichtungsapparat (5; 40; 50; 55; 65; 70; 75; 80; 85; 100; 170) gemäß einem der Ansprüche 1 bis 7, bei dem das optische Illuminationssystem (10, 14, 15a, 15b, 16, 17, 18, 19) eine numerische Apertur $NA_i$ hat, das optische Projektionssystem (21) eine numerische Apertur $NA_p$ hat und bei dem die photo-reinigende Einheit (30) wirksam ist zum Erfüllen der Bedingung

$$NA_i \geq NA_p.$$

9. Verfahren zum Herstellen von Halbleitervorrichtungen, welches die nachfolgenden Schritte aufweist:

a) Bereitstellen eines optischen Systems mit einer Mehrzahl optischer Elemente (15a, 15b, 17, 18, 19, 20, 21), um so eine Strichplatte (20) mit einem Muster auf ein photosensitives Substrat (22) zu belichten;
b) Photo-Reinigen von mindestens einem der Mehrzahl optischer Elemente (15a, 15b, 17, 18, 19, 20, 21), dadurch Vergrößern entweder (i) des Transmissionsgrades oder (ii) des Reflexionsgrades des mindestens einen der Mehrzahl optischer Elemente (15a, 15b, 17, 18, 19, 20, 21) mittels Leitens von Licht einer vorgegebenen Wellenlänge, welches von dem mindestens einen der Mehrzahl optischer Elemente (15a, 15b, 17, 18, 19, 20, 21) des optischen Systems geleitetet wird; und
c) Belichten des Strichplatten-Musters auf das photosensitive Substrat (22) unter Verwenden des optischen Systems.

10. Verfahren gemäß Anspruch 9, ferner aufweisend den nachfolgenden Schritt:

d) Messen entweder (i) des Transmissionsgrades oder (ii) des Reflexionsgrades des mindestens einen der Mehrzahl optischer Elemente (15a, 15b, 17, 18, 19, 20, 21).

11. Verfahren gemäß Anspruch 10, ferner aufweisend den Schritt des Ermittelns, ob mindestens einer der Schritte b) und c) ausgeführt wurde oder ob der Schritt c) ausgeführt wurde, basierend auf dem Schritt d).

12. Verfahren gemäß einem der Ansprüche 9 bis 11, wobei:

A) Schritt c) mittels Beleuchtens des Musters auf der Strichplatte (20) mit von einem optischen Illuminationssystem, welches in der Mehrzahl optischer Elemente (15a, 15b, 17, 18, 19, 20, 21) enthalten ist, erzeugten Licht und Projizierens eines Bildes des Musters durch eine optisches Projektionssystem (21), welches in der Mehrzahl optischer Elemente (15a, 15b, 17, 18, 19, 20, 21) enthalten ist, n Mal ($n \geq 0$) durchgeführt, wird, wobei das optische Projektionssystem (21) einen optischen Projektionssystem-Transmissionsgrad hat; und
B) Schritt b) nach n Belichtungen vor Durchführen einer n+1 Belichtung mit dem Licht von dem optischen Illuminationssystem durchgeführt wird, um so zum Wiederherstellen eines optimalen Transmissionsgrades des optischen Projektionssystems (21) den optischen Projektionssystem-Transmissionsgrad zu verbessern.

13. Verfahren gemäß einem der Ansprüche 9 bis 12, ferner aufweisend den nachfolgenden Schritt:

e) Steuern des optischen Systems derart, dass es in dem Schritt b) während des Bestrahlungsprozesses eine numerische Apertur $NA_{i1}$ und in dem Schritt c) während des Durchführens des Belichtungsprozesses eine numerische Apertur $NA_{i2}$ hat, und dass

$$NA_{i1} \geq NA_{i2}.$$

14. Verfahren gemäß einem der Ansprüche 9 bis 13, bei dem das optische System ein optisches Projektionssystem (21) mit einer numerischen Apertur $NA_p$ und ein optisches Illuminationssystem (10, 14, 15a, 15b, 16, 17, 18, 19) mit einer numerischen Apertur $NA_{i1}$ aufweist, und bei dem in dem Schritt b) der Belichtungsprozess so durchgeführt wird zum Erfüllen der Bedingung

$$NA_{i1} \geq NA_p.$$

15. Verfahren gemäß einem der Ansprüche 9 bis 11, bei dem das optische System ein optisches Projektionssystem (21) mit einer Mehrzahl optischer Komponenten (L1, L2, L3, L4, L5) mit einer Mehrzahl von Zwischenräumen (C1, C2, C3, C4) dazwischen aufweist, und ferner aufweist den Schritt des Einblasens eines Edelgases in die Mehrzahl von Zwischenräumen (C1, C2, C3, C4) des optischen Projektionssystems (21), und dann des Ausströmens des Edelgases aus der Mehrzahl von Zwischenräumen (C1, C2, C3, C4).

**16.** Verfahren gemäß einem der Ansprüche 9 bis 14, ferner aufweisend den Schritt des Einblasens eines vorgegebenen Gases in das optische System (13, 14, 18, 19, 20, 21).

**17.** Verfahren gemäß Anspruch 16, ferner aufweisend den Schritt des Ausströmens des vorgegebenen Gases aus dem optischen System (13, 14, 18, 19, 20, 21).

**18.** Verfahren gemäß Anspruch 16 oder 17, bei dem das vorgegebene Gas ein Edelgas aufweist.

**19.** Optischer Belichtungsapparat (5; 40; 50; 55; 65; 70; 75; 80; 85; 100; 170) gemäß Anspruch 7, ferner aufweisend eine Ausström-Einheit (130) zum Ausströmen des vorgegebenen Gases aus dem optischen System.

**20.** Optischer Belichtungsapparat (5; 40; 50; 55; 65; 70; 75; 80; 85; 100; 170) gemäß Anspruch 19, bei dem das vorgegebene Gas ein Edelgas aufweist.

**21.** Optischer Belichtungsapparat (5; 40; 50; 55; 65; 70; 75; 80; 85; 100; 170) gemäß einem der Ansprüche 1 bis 7 und 19 und 20, bei dem die photo-reinigende Einheit (30) ein photo-reinigendes Teil (72) aufweist, welches an einer Stelle angeordnet ist, wo eine Strichplatte (20) mit einem vorgegebenen Muster platziert ist.

**22.** Optischer Belichtungsapparat (5; 40; 50; 55; 65; 70; 75; 80; 85; 100; 170) gemäß einem der Ansprüche 1 bis 7 und 19 bis 21, bei dem das optische System eine Strahlveränderungseinheit (14) zum Verändern eines Strahls der Lichtquelle (10) in einen ringförmigen Strahl und zum Verändern eines Ringverhältnisses des ringförmigen Strahls aufweist.

**23.** Optischer Belichtungsapparat (5; 40; 50; 55; 65; 70; 75; 80; 85; 100; 170) gemäß einem der Ansprüche 1 bis 7 und 19 bis 21, bei dem das optische System eine Strahlveränderungseinheit (14) zum Verändern eines Strahls der Lichtquelle (10) in mehrere außermittige Strahlen aufweist.

**24.** Optischer Belichtungsapparat (5; 40; 50; 55; 65; 70; 75; 80; 85; 100; 170) gemäß einem der Ansprüche 1 bis 7 und 19 bis 23, bei dem die Wellenlänge des Lichts der Lichtquelle (10) kleiner als 200 nm ist.

**25.** Verfahren gemäß einem der Ansprüche 9 bis 18, bei dem der Schritt b) den Schritt des Verwendens eines Belichtungslichts mit der in Schritt c) verwendeten, vorgegebenen Wellenlänge aufweist.

**26.** Verfahren gemäß einem der Ansprüche 9 bis 18 und 25, bei dem der Schritt c) ferner den Schritt des Verwendens einer in dem optischen System enthaltenen Strahlveränderungseinheit (14) aufweist, um so einen Strahl der Lichtquelle (10) in einen ringförmigen Strahl zu verändern und ein Ringverhältnis des ringförmigen Strahls zu verändern.

**27.** Verfahren gemäß einem der Ansprüche 9 bis 18 und 25, bei dem der Schritt c) ferner den Schritt des Verwendens einer in dem optischen System enthaltenen Strahlveränderungseinheit (14) aufweist, um so einen Strahl der Lichtquelle (10) in mehrere außermittige Strahlen zu verändern.

**28.** Verfahren gemäß einem der Ansprüche 9 bis 18 und 25 bis 27, bei dem die Wellenlänge des in den Schritten b) und c) verwendeten Lichts kleiner als 200 nm ist.

## Revendications

**1.** Dispositif d'exposition optique (5 ; 40 ; 50 ; 55 ; 65 ; 70 ; 75 ; 80 ; 85 ; 100 ; 170) comportant :

> a) une source lumineuse (10) émettant une lumière ayant une longueur d'onde prédéterminée,
> b) un système optique comportant une pluralité d'éléments optiques (15a, 15b, 17, 18, 19, 20, 21) pour exposer un substrat photosensible (22) à l'aide de ladite lumière ayant ladite longueur d'onde prédéterminée, et
> c) une unité de photo-nettoyage (30) pour améliorer une première caractéristique parmi (i) la transmittance et (ii) la réflectance d'au moins un élément parmi ladite pluralité d'éléments optiques (15a, 15b, 17, 18, 19, 20, 21),

> dans lequel l'unité de photo-nettoyage (30) est adaptée pour nettoyer optiquement une surface dudit au moins un élément de ladite pluralité d'éléments optiques (15a, 15b, 17, 18, 19, 20, 21) par l'intermédiaire de ladite lumière ayant ladite longueur d'onde prédéterminée guidée par ledit au moins un élément de ladite pluralité d'éléments optiques (15a, 15b, 17, 18, 19, 20, 21) dudit système optique.

**2.** Dispositif d'exposition optique (5 ; 40 ; 50 ; 55 ; 65 ; 70 ; 75 ; 80 ; 85 ; 100 ; 170) selon la revendication 1, dans lequel ladite unité de photo-nettoyage (30) est positionnée entre ladite source lumineuse (10) et ledit substrat photosensible (22) à exposer.

**3.** Dispositif d'exposition optique (5 ; 40 ; 50 ; 55 ; 65 ; 70 ; 75 ; 80 ; 85 ; 100 ; 170) selon la revendication 1, dans lequel ledit système optique est positionné entre ladite source lumineuse (10) et ladite unité de photo-nettoyage (30).

**4.** Dispositif d'exposition optique (5 ; 40 ; 50 ; 55 ; 65 ; 70 ; 75 ; 80 ; 85 ; 100 ; 170) selon l'une quelconque des revendications 1 à 3, comportant de plus :

    a) un système de mesure (24, 26, 34, 36 ; 42, 44a, 44d) pour mesurer ladite première caractéristique parmi (i) ladite transmittance et (ii) ladite réflectance dudit au moins un élément de ladite pluralité d'éléments optiques (15a, 15b, 17, 18, 19, 20, 21), et
    b) un système de commande (27, 32) connecté à ladite unité de photo-nettoyage (30) et audit système de mesure (24, 26, 34, 36 ; 42, 44a, 44d) pour changer ladite unité de photo-nettoyage (30).

**5.** Dispositif d'exposition optique (5 ; 40 ; 50 ; 55 ; 65 ; 70 ; 75 ; 80 ; 85 ; 100 ; 170) selon l'une quelconque des revendications 1 à 4, dans lequel ledit système optique comporte un système optique d'illumination (10, 14, 15a, 15b, 16, 17, 18, 19).

**6.** Dispositif d'exposition optique (5 ; 40 ; 50 ; 55 ; 65 ; 70 ; 75 ; 80 ; 85 ; 100 ; 170) selon l'une quelconque des revendications 1 à 4, dans lequel ledit système optique comporte un système optique d'illumination (10, 14, 15a, 15b, 16, 17, 18, 19) et un système optique de projection (21).

**7.** Dispositif d'exposition optique (5 ; 40 ; 50 ; 55 ; 65 ; 70 ; 75 ; 80 ; 85 ; 100 ; 170) selon l'une quelconque des revendications 1 à 6, comportant de plus :

    A) un réticule (20) ayant un motif, ledit réticule (20) étant positionné à proximité adjacente dudit système optique d'illumination (10, 14, 15a, 15b, 16, 17, 18, 19),
    B) une ouverture variable (14, 16) pour commander une ouverture numérique dudit système optique d'illumination (10, 14, 15a, 15b, 16, 17, 18, 19),
    C) un système de mesure de transmittance (24, 26),
    D) un faisceau lumineux (11), et
    E) un système de commande (27, 32) connecté audit système de mesure de transmittance (24, 26) et à ladite ouverture variable (14, 16) pour changer ladite ouverture variable (14, 16) de manière à changer ladite ouverture numérique,

    dans lequel

    a) ladite ouverture variable (14, 16) est une partie dudit système optique d'illumination (10, 14, 15a, 15b, 16, 17, 18, 19),
    b) ledit système optique d'illumination (10, 14, 15a, 15b, 16, 17, 18, 19) comporte ladite ouverture variable (14, 16) et ayant une transmittance de système optique d'illumination,
    c) ledit système optique de projection (21) est positionné à proximité adjacente dudit réticule (20) et à l'opposé dudit système optique d'illumination (10, 14, 15a, 15b, 16, 17, 18, 19), et à proximité adjacente d'un substrat photosensible (22), et a une transmittance de lentille optique, et
    d) ledit système de mesure de transmittance (24, 26) mesure au moins une première caractéristique parmi ladite transmittance de système optique d'illumination et ladite transmittance de lentille de projection.

**8.** Dispositif d'exposition optique (5 ; 40 ; 50 ; 55 ; 65 ; 70 ; 75 ; 80 ; 85 ; 100 ; 170) selon l'une quelconque des revendications 1 à 7, dans lequel ledit système optique d'illumination (10, 14, 15a, 15b, 16, 17, 18, 19) a une ouverture numérique $NA_i$, ledit système optique de projection (21) a une ouverture numérique $NA_p$ et dans lequel ladite unité de photo-nettoyage (30) agit pour satisfaire à la condition suivante

$$NA_i \geq NA_p.$$

**9.** Procédé pour fabriquer des dispositifs à semi-conducteurs comportant les étapes consistant à :

    a) fournir un système optique ayant une pluralité d'éléments optiques (15a, 15b, 17, 18, 19, 20, 21) de manière à exposer un réticule (20) ayant un motif sur un substrat photosensible (22),
    b) photo-nettoyer au moins un élément de ladite pluralité d'éléments optiques (15a, 15b, 17, 18, 19, 20, 21), de manière à augmenter une première caractéristique parmi (i) la transmittance et (ii) la réflectance dudit au moins un élément de ladite pluralité d'éléments optiques (15a, 15b, 17, 18, 19, 20, 21) par le guidage d'une lumière ayant une longueur d'onde prédéterminée guidée par ledit au moins un élément de ladite pluralité d'éléments optiques (15a, 15b, 17, 18, 19, 20, 21) dudit système optique, et
    c) exposer ledit motif de réticule sur ledit substrat photosensible (22) en utilisant ledit système optique.

**10.** Procédé selon la revendication 9, comportant de plus l'étape consistant à :

d) mesurer ladite première caractéristique parmi (i) la transmittance et (ii) la réflectance dudit au moins un élément de ladite pluralité d'éléments optiques (15a, 15b, 17, 18, 19, 20, 21).

11. Procédé selon la revendication 10, comportant de plus l'étape consistant à déterminer si au moins une étape parmi ladite étape b) et ladite étape c) est effectuée ou si l'étape c) est effectuée, sur la base de ladite étape d).

12. Procédé selon l'une quelconque des revendications 9 à 11, dans lequel :

A) l'étape c) est effectuée n fois ($n \geq 0$) en illuminant ledit motif sur ledit réticule (20) à l'aide d'une lumière générée par un système optique d'illumination qui est constitué de ladite pluralité d'éléments optiques (15a, 15b, 17, 18, 19, 20, 21) et en projetant une image dudit motif à travers un système optique de projection (21) qui est constitué de ladite pluralité d'éléments optiques (15a, 15b, 17, 18, 19, 20, 21), ledit système optique de projection (21) ayant une transmittance de système optique de projection, et
B) l'étape b) est effectuée après avoir effectué n expositions avant d'effectuer une n+1 exposition en irradiant ledit système optique de projection (21) à l'aide de ladite lumière provenant dudit système optique d'illumination de manière à améliorer ladite transmittance de système optique de projection afin de restaurer une transmittance optimale dudit système optique de projection (21).

13. Procédé selon l'une quelconque des revendications 9 à 12, comportant de plus l'étape consistant à :

e) commander ledit système optique de sorte qu'il a une ouverture numérique $NA_{i1}$ à ladite étape b) pendant ledit processus d'irradiation, et une ouverture numérique $NA_{i2}$ à ladite étape c) alors que le processus d'exposition est mis en oeuvre, et de sorte que

$$NA_{i1} \geq NA_{i2}.$$

14. Procédé selon l'une quelconque des revendications 9 à 13, dans lequel ledit système optique comporte un système optique de projection (21) ayant une ouverture numérique $NA_p$ et un système optique d'illumination (10, 14, 15a, 15b, 16, 17, 18, 19) ayant une ouverture numérique $NA_{i1}$, et dans lequel à ladite étape b), un processus d'irradiation est effectué de manière à satisfaire à la condition suivante :

$$NA_{i1} \geq NA_p.$$

15. Procédé selon l'une quelconque des revendications 9 à 11, dans lequel ledit système optique comportant un système optique de projection (21) ayant une pluralité de composants optiques (L1, L2, L3, L4, L5) présentant une pluralité d'espaces (C1, C2, C3, C4) entre ceux-ci, et comportant de plus l'étape consistant à injecter un gaz inerte dans ladite pluralité d'espaces (C1, C2, C3, C4) dudit système optique de projection (21) et à décharger alors ledit gaz inerte depuis ladite pluralité d'espaces (C1, C2, C3, C4).

16. Procédé selon l'une quelconque des revendications 9 à 14, comportant de plus l'étape consistant à injecter un gaz prédéterminé dans ledit système optique (13, 14, 18, 19, 20, 21).

17. Procédé selon la revendication 16, comportant de plus l'étape consistant à décharger le gaz prédéterminé depuis ledit système optique (13, 14, 18, 19, 20, 21).

18. Procédé selon la revendication 16 ou 17, dans lequel le gaz prédéterminé comporte un gaz inerte.

19. Dispositif d'exposition optique (5 ; 40 ; 50 ; 55 ; 65 ; 70 ; 75 ; 80 ; 85 ; 100 ; 170) selon la revendication 7, comportant de plus une unité de décharge (130) pour décharger le gaz prédéterminé depuis ledit système optique.

20. Dispositif d'exposition optique (5 ; 40 ; 50 ; 55 ; 65 ; 70 ; 75 ; 80 ; 85 ; 100 ; 170) selon la revendication 19, dans lequel le gaz prédéterminé comporte un gaz inerte.

21. Dispositif d'exposition optique (5 ; 40 ; 50 ; 55 ; 65 ; 70 ; 75 ; 80 ; 85 ; 100 ; 170) selon l'une quelconque des revendications 1 à 7 et 19 et 20, dans lequel ladite unité de photo-nettoyage (30) comporte un élément de photo-nettoyage (72) positionné à une position où est placé un réticule (20) ayant un motif prédéterminé.

22. Dispositif d'exposition optique (5 ; 40 ; 50 ; 55 ; 65 ; 70 ; 75 ; 80 ; 85 ; 100 ; 170) selon l'une quelconque des revendications 1 à 7 et 19 à 21, dans lequel ledit système optique comporte une unité de changement de faisceau (14) pour changer un faisceau provenant de ladite source lumineuse (10) en un faisceau annulaire et pour changer un rapport annulaire du faisceau annulaire.

23. Dispositif d'exposition optique (5 ; 40 ; 50 ; 55 ; 65 ; 70 ; 75 ; 80 ; 85 ; 100 ; 170) selon l'une quelconque des revendications 1 à 7 et 19 à 21, dans lequel ledit système optique comporte une unité de changement de faisceau (14) pour changer un faisceau provenant de ladite source lumineuse (10) en multiples faisceaux décentrés.

24. Dispositif d'exposition optique (5 ; 40 ; 50 ; 55 ; 65 ; 70 ; 75 ; 80 ; 85 ; 100 ; 170) selon l'une quelconque des revendications 1 à 7 et 19 à 23, dans lequel la longueur d'onde de ladite lumière provenant de ladite source lumineuse (10) est inférieure à 200 nanomètres.

25. Procédé selon l'une quelconque des revendications 9 à 18, dans lequel ladite étape b) inclut l'étape consistant à utiliser une lumière d'exposition ayant ladite longueur d'onde prédéterminée utilisée à l'étape c).

26. Procédé selon l'une quelconque des revendications 9 à 18 et 25, dans lequel ladite étape c) comporte de plus l'étape consistant à utiliser une unité de changement de faisceau (14) incluse dans ledit système optique de manière à changer un faisceau provenant de ladite source lumineuse (10) en un faisceau annulaire et à changer un rapport annulaire du faisceau annulaire.

27. Procédé selon l'une quelconque des revendications 9 à 18 et 25, dans lequel ladite étape c) comporte de plus l'étape consistant à utiliser une unité de changement de faisceau (14) incluse dans ledit système optique de manière à changer un faisceau provenant de ladite source lumineuse (10) en de multiples faisceaux décentrés.

28. Procédé selon l'une quelconque des revendications 9 à 18 et 25 à 27, dans lequel la longueur d'onde de ladite lumière utilisée à l'étape b) et à ladite étape c) est inférieure à 200 nanomètres.

# FIG.1

# FIG.2

# FIG.3

FIG.4

# FIG.5

# FIG.6

# FIG.7

FIG.8

EP 0 874 283 B1

FIG.9

31

FIG.10

FIG.11

**FIG.12**

**FIG.13**

## FIG.14

FIG. 15